# EUROPEAN PATENT SPECIFICATION

(11) **EP 2 364 072 B1**
(45) Date of publication and mention of the grant of the patent: **28.01.2015**
(21) Application number: 11153140.6
(22) Date of filing: 03.02.2011
(51) Int. Cl.: H05K 3/12, H05K 13/08, G01B 11/28, G01B 11/06, H05K 3/22

(54) **Method for supporting analytical work of solder printing state and solder printing inspection machine**
Verfahren zur Unterstützung der analytischen Arbeit des Lötdruckstatus und Lötdruckprüfmaschine
Procédé pour supporter le travail analytique d'un état d'impression de soudure et machine d'inspection d'impression de soudure

(30) Priority: 05.03.2010 JP 2010049087
(43) Date of publication of application: 07.09.2011
(73) Proprietor: Omron Corporation, Kyoto-shi, Kyoto 600-8530 (JP)
(72) Inventor: Mori, Hiroyuki, Kyoto-shi, Kyoto 600-8530 (JP)
(74) Representative: Kilian Kilian & Partner

(56) References cited:
- DE-A1- 10 040 335
- US-A1- 2002 014 602

## Description

### BACKGROUND OF THE INVENTION

### 1. TECHNICAL FIELD

The present invention relates to a method for inspecting a solder printing state of a board in which cream solder is printed before a component is mounted and supporting analytical work of the solder printing state based on the inspection result, and a solder printing inspection machine in which the method is adopted.

### 2. RELATED ART

in a solder printing process that is a first process on a component mounting board production line, it is necessary to transfer a proper amount of solder to many electrodes (lands) on the board, However, sometimes quality of printing region is degraded due to mask exchange or mask clogging in a solder printer and a fluctuation in supply of the cream solder.

In order to solve the problem, the applicant previously proposed that a graph in which an amount of solder on the board is inspected after the solder printing and the amount of solder measured in each inspection is arrayed along a temporal axis, is produced and displayed on a display unit of the inspection machine (see Japanese Unexamined Patent Publication No. 8-261732).

In the invention of Japanese Unexamined Patent Publication No. 8-261732, a user can easily confirm whether or not the quality is degraded in the solder printing region from the displayed graph. When the user confirms that the quality is degraded, the quality can be recovered by taking necessary measures such as maintenance of the solder printer.

There is also a proposal in which various pieces of analytical information are produced from inspection result with respect to not only the solder printing process but also all the processes of the production line. For example, in a proposal disclosed in Japanese Unexamined Patent Publication No. 6-112295, inspection machines are individually disposed in a solder printing process, a component mounting process, and a reflow process, a measured value obtained by the inspection in each process and a production condition set to production facility are collected, the quality of the board passing through each facility is analyzed in each of various monitoring items using these measured value and production condition, and the analytical result is displayed on a monitor or copied.

Recently, in the production site, an identification code unique to each board is provided by a method such as marking and adhesion of a seal, the identification code is read when the production facility or the inspection machine receives the board, and the inspection result is stored while bundled with the identification code (for example, see Japanese Unexamined Patent Publication No. 2005-303269). In the method of Japanese Unexamined Patent Publication No. 2005-303269, advanced analytical processing can be performed such that one board is confirmed while correlated with processing result of each process.

In the proposal of Japanese Unexamined Patent Publication No. 8-261732, an area of the cream solder is fixed as the amount of solder through the two-dimensional image processing. Alternatively, as disclosed in Japanese Patent No. 2711042, there is an inspection machine that measures a thickness (height) and a volume of the cream solder.

In the production site of actual component mounting board, when a clear defect is generated in the solder printing process, sometimes the defective board is extracted from the production line and the board is washed and reintroduced to the production line (reuse of board). The reuse of board is based on a thought that cost is reduced by decreasing the number of discarded boards. However, it is not always confirmed that the total cost is actually reduced.

In the actual operation, it is found that sometimes the defect is easily generated by reintroducing the board. For example, when the extracted board is insufficiently washed, sometimes the new solder is printed on the previous solder to become excess solder during the reintroduction. When a mask is pressed with a squeeze while placed on the board in which the excess solder is generated, sometimes the solder seeps outside the land to generate a severe defect. The seeped solder adheres to the mask, and sometimes the solder adheres to a position except the land of a subsequently processed board to increase the number of defective boards.

Because the board is manually extracted, washed, and reintroduced, productivity is lowered by performing the extracting work, washing work, and reintroducing work. Accordingly, when a new defect is generated by reintroducing the extracted board, sometimes the defective board is advantageously discarded rather than the reuse. Accordingly, in the production site, it is necessary to specify the reintroduced board and the board immediately before the reintroduced board to check the quality of the board, and to examine whether or not the reintroduced board has an advantage.

In order to improve the productivity, it is necessary to prevent the board quality from being degraded to such an extent that the extraction is required. Therefore, desirably the extracted board can be specified to analyze the production condition and the solder printing state in processing the board. However, conventionally the analysis is not easily performed in the production site.

DE 100 40 335 A1 is directed to a method and apparatus for cleaning electronic components such as circuit boards contaminated with solder paste in a printing process by using a dry ice particle beam, wherein the contaminated components are irradiated with a particle beam consisting of dry ice particles, and the beam may have a high particle density, and a low velocity. The particles preferably have a diameter of 0.01 to 1 mm and may be formed by pressing CO₂ snow or by crushing large dry ice particles. The cleaned circuit boards are reintroduced into the printing process.

### SUMMARY

The present invention has been devised to solve the problems described above, and an object thereof is to be able to easily confirm an influence of the extraction or reintroduction of the board in the solder printing process on the board quality by the user.

The object is solved by the method for supporting analytical work of a solder printing state of a solder printer according to claim 1 and the solder printing inspection machine according to claim 4.

In accordance with one aspect of the present Invention, there is provided a method for supporting analytical work of a solder printing state, a plurality of boards being sequentially introduced and processed in a production line including a solder printer and a solder printing inspection machine, a unique identification code being provided on each of the plurality of boards, the solder printing inspection machine producing inspection result data bundled with the identification code on each board and information specifying an inspection order, the inspection result data being accumulated in a solder printing inspection machine or a memory of an external device.

For example, the time each board is inspected can be used as the "information specifying the inspection order". Alternatively, the number indicating the inspection order may be used.

A first step, a second step, and a third step are performed in the supporting method according to the present invention. The first, second, and third steps can be performed with not only a solder printing inspection machine, but also an external computer that receives inspection result data from the solder printing inspection machine. Alternatively, the solder printing inspection machine and the external computer can perform the first, second, and third steps while dividing the first step, the second step, and the third step.

In the first step, each of the plurality of boards introduced to the solder printing inspection machine for a purpose of inspection is focused, pieces of inspection result data of the plurality of boards that are inspected before the focused board is introduced to the solder printing inspection machine based on the information specifying the inspection order is specified, the identification codes bundled with the pieces of inspection result data is checked against the identification code of the focused board, and when the inspection result data bundled with the identification code identical to that of the focused board is detected by the checking, it is recognized that the focused board is a board corresponding to the inspection result data bundled with the identical identification code and is reintroduced to the production line.

In the second step, a graph in which pieces of quality data of the plurality of boards are arrayed in time series is produced using the pieces of inspection result data of the plurality of boards inspected by the solder printing inspection machine, the plurality of boards including the board recognized in the first step. In the third step, the graph produced in the second step based on the recognition result in the first step is displayed while the quality data corresponding to at least one of the reintroduced board and a board corresponding to the inspection result data bundled with the identification code identical to that of the reintroduced board is explicitly shown. Examples of the data indicating the board quality include the number of defective regions in the board, a percent defective of the defective regions and a ratio of the non-defective region. Alternatively, numbers (such as an average, a standard deviation, and a difference between a maximum value and a minimum value) that are obtained by statistical processing of the measured values such as an area, a volume, and a height of the cream solder may be used as the data indicating the board quality.

In the above method, from the displayed graph, the user can confirm a change in quality with respect to the plurality of boards introduced to the production line, and the user can confirm the quality of the reintroduced board that is processed in the past or the quality at the time the reintroduced board is processed in the past. Therefore, the user can easily recognize an influence of the extraction or reintroduction of the board on the quality.

In a preferred aspect of the above method, the solder printing inspection machine is configured to perform the first, second, and third steps, and to accumulates the inspection result data in a memory of the solder printing inspection machine. The solder printing inspection machine focuses on an inspection target board to perform the first step each time the inspection target board is received, and upon oompleting the inspection of the inspection target board performs the second step and the third step targeting the plurality of boards inspected prior to the inspection target board. In the third step, the quality data corresponding to the reintroduoced board is explicitly shown in the graph, and when display target graph includes data of the board corresponding to the inspection result data bundled with the identification code identical to that of the reintroduced board, the data is explicitly shown as the quality data corresponding to a board extracted from the production line in a mode different from the quality data corresponding to the reintroduced board. The first step may be performed either before or after the inspection target board is inspected.

According to the above aspect, each time solder printing inspection machine receives the new inspection target board to perform the inspection, the displayed graph is updated to the graph expressing the change in quality of the board and the plurality of boards inspected prior to the board. The data corresponding to the board that is extracted and reintroduced in the past is explicitly shown in the graph, so that the user can easily recognize the influence of the board reintroduction on the quality.

When the graph includes the data corresponding to the extracted board, the data corresponding to the extracted board is explicitly shown in a mode different from that of the data corresponding to the reintroduced board, so that the user can easily recognize a casual relationship even if the defects are generated in the reintroduced board and the board subsequent thereto to extract the defective boards.

In another preferred aspect of the above method, the solder printer is configured to transmit data relating to a producing condition of a board processed by the solder printer and bundled with the identification code to an external computer, the external computer being able to communicate with the solder printer and the solder printing inspection machine, and the solder printing inspection machine is configured to transmit the inspection result data of the board to the external computer to let the inspection result data along with the data transmitted from the solder printer stored as information in a memory of the external computer. The external computer performs the first, second, and third steps to a plurality of identical-specification boards processed by the solder printer and the solder printing inspection machine.

In the second step, a graph in which pieces of quality data expressing quality of the boards are arrayed in time series and a graph in which pieces of data expressing the board producing conditions are arrayed in time series are produced using the information accumulated in the memory of the external computer, In the third step, the quality data expressing the quality and the data expressing the producing condition of the graphs produced in the second step are displayed in a line with respect to the identification code of the board, and the quality data corresponding to the inspection result data bundled with the identification code identical to that of the reintroduced board is explicitly shown as the quality data corresponding to a board extracted from the production line.

According to the above aspect, from the displaced graph, the user can confirm the influence of the change of the production condition on the quality with respect to the plurality of identical-specification boards processed by the solder printer and the solder printing inspection machine, and the user can also confirm the production condition at the time the board extraction is generated and the production condition before and after the time the board extraction is generated. Therefore, the cause that the quality is degraded to such an extent that the board extraction is required can be specified to consider necessary measures to solve the cause.

In accordance with another aspect of the present invention, a solder printing inspection machine includes: an inspection performing unit that sequentially receives a plurality of boards processed through solder printing by a solder printer to inspect a printing state of solder, a unique identification code being provided on each of the plurality of boards; an inspection result accumulation unit that produces and accumulates inspection result data of each of the plurality of boards therein or in an external device, the inspection result data being bundled with the identification code of each of the plurality of boards and information specifying an inspection order; and an information display unit that produces a graph using the produced inspection result data and displays the graph on a monitor device, the graph showing pieces of quality data expressing quality of the boards arrayed in time series.

The solder printing inspection machine further includes a recognition unit that specifies pieces of inspection result data of the plurality of boards that have been inspected before an inspection target board is received based on the information specifying the inspection order each time the inspection target board is received, checks the identification codes bundled with the pieces of inspection result data against the identification code of the inspection target board, and when the inspection result data bundled with the identification code identical to that of the inspection target board is detected by the checking, recognizes that the inspection target board is a board corresponding to the inspection result data bundled with the identical identification code and is reintroduced to the production line. Further, the information display unit updates display target graph using the inspection result data produced for the board each time the inspection of the received board is ended, and explicitly displays the quality data corresponding to the reintroduced board in the graph based on the recognition result of the recognition unit.

in the above solder printing inspection machine, the user can confirm the quality of the reintroduced board and the quality of the board subsequent to the reintroduced board from the graph displayed on the monitor while performing the inspection.

In a preferred aspect of the soldier printing inspection machine, when the display target graph includes the quality data of the board corresponding to the inspection result data bundled with the identification code identical to that of the reintroduced board, the information display unit explicitly shows the data as a quality data corresponding to the board extracted from the production line in a mode different from the quality data corresponding to the reintroduced board. In the display of the information display unit, when the defect is generated in the reintroduced board or the board subsequent to the reintroduced board to extract the defective board, the processing is explicitly shown in the graph, so that the user can easily recognize that the reintroduction of the board causes the new defect.

According to the present invention, the reintroduced board that is processed in the past is recognized in the plurality of boards that are introduced to the production line to perform the solder printing, the graph expressing the quality of each of the plurality of boards is displayed while explicitly showing the data corresponding to the board in which the reintroduction is recognized, so that the user can easily confirm a relationship between the board extraction or reintroduction and the board quality. Therefore, the examination whether or not the productivity is improved by the board reintroduction and the processing of analyzing the situation at the time the board is extracted can properly be performed to improve the productivity.

### BRIEF DESCRIPTION OF THE DRAWINGS

Fig. 1 is a block diagram illustrating a configuration of a solder printing inspection machine;
Fig. 2 is a view illustrating an example of an inspection result confirmation screen in the solder printing inspection machine;
Fig, 3 is a view illustrating another example of a graph displays field;
Fig. 4 is a view illustrating still another example of the graph display field;
Fig. 5 is a view illustrating yet another example of the graph display field;
Fig. 6 is a functional block diagram illustrating a control system of the solder printing inspection machine;
Fig. 7 is a view illustrating an example of a data configuration of a passage board table;
Fig. 8 is a view illustrating another example of the data configuration of the passage board table;
Fig. 9 is a flowchart schematically illustrating a processing procedure in the solder printing inspection machine;
Fig. 10 is a flowchart illustrating a detailed procedure of registration processing in the passage board table;
Fig. 11 is a view illustrating another example of the graph display field;
Figs. 12A to 12C are views illustrating an example of the data configuration of the passage board table in performing display of Fig. 11 and a change of data with time;
Fig. 13 is a flowchart illustrating a procedure for the registration processing in the passage board table of Figs. 12A to 12C;
Fig. 14 is a view illustrating configuration examples of a board production line and a board quality management system;
Fig. 15 is a view illustrating an example of a confirmation screen displayed on a terminal device of the quality management system of Fig. 14;
Fig. 16 is a functional block diagram illustrating functions set to a server of the quality management system with respect to the displays of Fig. 15;
Fig. 17 is a diagram illustrating an example of the data configuration of the passage board table in consideration of board extraction in a component mounting process; and
Fig. 18 is a flowchart illustrating a procedure for the registration processing in the passage board table of Fig. 17.

### DETAILED DESCRIPTION

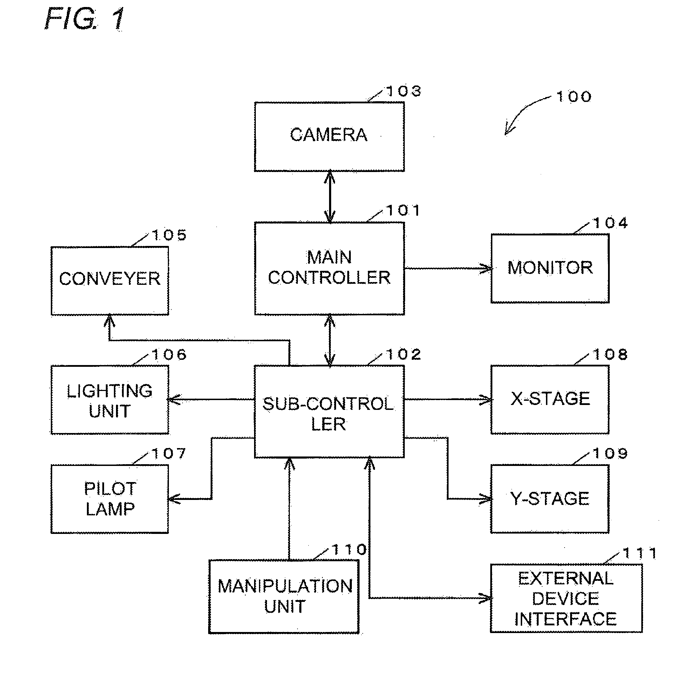

Fig. 1 is a block diagram illustrating a configuration of a solder printing inspection machine 100.
The solder printing inspection machine 100 is installed in a solder printing process of a component mounting board production line to inspect whether or not an amount of spider printed in an electrode (land) on a board side or a printing range of the solder is proper.

In Fig. 1, a main controller 101 and a sub-controller 102 are computers including CPUs and memories.
The main controller 101 includes a communication interface that conducts network communication. The main controller 101 is connected to a camera 103 and a monitor 104. The sub-controller 102 is connected to a conveyer 105, a lighting unit 106, a pilot lamp 107, an X-stage 108, a Y-stage 109, a manipulation unit 110, an external device interface 111, and the like.

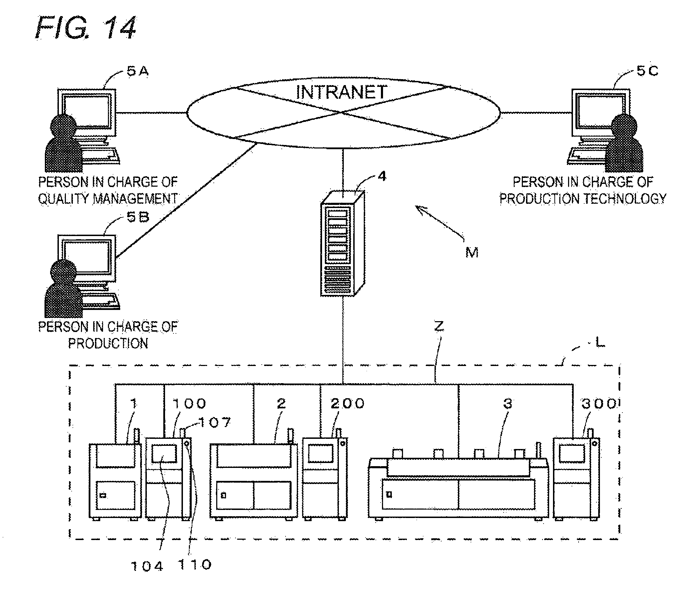

As illustrated in Fig. 14 which will be described later, the monitor 104, the pilot lamp 107, and the manipulation unit 110 are attached to a chassis of the solder printing inspection machine 100, and other components are accommodated in the chassis. The sub-controller 102 controls operations of the conveyer 105, lighting unit 106, pilot lamp 107, X-stage 108, and Y-stage 1 09 in response to an instruction from the main controller 101. The sub-controller 102 receives an input from the manipulation unit 110 or eternal device interface 111 and transmits the input information to the main controller 101. The sub-controller 102 also controls an operation of an external device (such as a printer, not illustrated) through the external device interface 111 in response to an instruction from the main controller 101.

The conveyer 105 carries in and takes out an inspection target board, and the conveyer 105 supports the board under inspection in a horizontal position. The X-stage 108 supports the camera 103 and the lighting unit 106 while the camera 103 and the lighting unit 106 can move in an X-axis direction. The Y-stage 109 supports the conveyer 105 while the conveyer 105 can move in a Y-axis direction.

The main controller 101 performs the inspection based on a program and setting data, which are registered in a memory. In brief description, the main controller 101 causes the sub-controller 102 to control the operations of the stages 108 and 109, and the main controller 101 causes the camera 103 to perform imaging while a visual field of the camera 103 is set to a predetermined range of the board. An inspection area is set to each solder printing region in the produced image, the image is binarized in each inspection area to extract a solder printing pattern, and an area and position of the solder printing pattern are measured to determines whether or not a measured value is proper.
Usually the camera 103 images the board plural times while the range corresponding to the visual field is changed.

An inspection program including the setting data and determination threshold of the inspection area is registered in the memory of the main controller 101 in each type of the board. After receiving a program selecting manipulation, the main controlled 101 reads the selected program to perform the inspection.

Each time the inspection of the board is ended, the main controller 101 collects the inspection results of the inspection areas to produce inspection result data. The inspection result data is stored in an internal memory of the main controller 101 while transmitted to a server 4 (described later) or the like.
The main controller 101 displays a confirmation screen for a field person in charge on the monitor 104 and updates the confirmation screen each time the inspection of the board is ended.

In the embodiment as described above, the apparatus that measures the area and position of the solder printing pattern through the two-dimensional image processing is used as the solder printing inspection machine 100. Alternatively, an inspection machine having a function of measuring the height and area of the solder printing pattern may be used as disclosed in Japanese Patent No. 2711042.

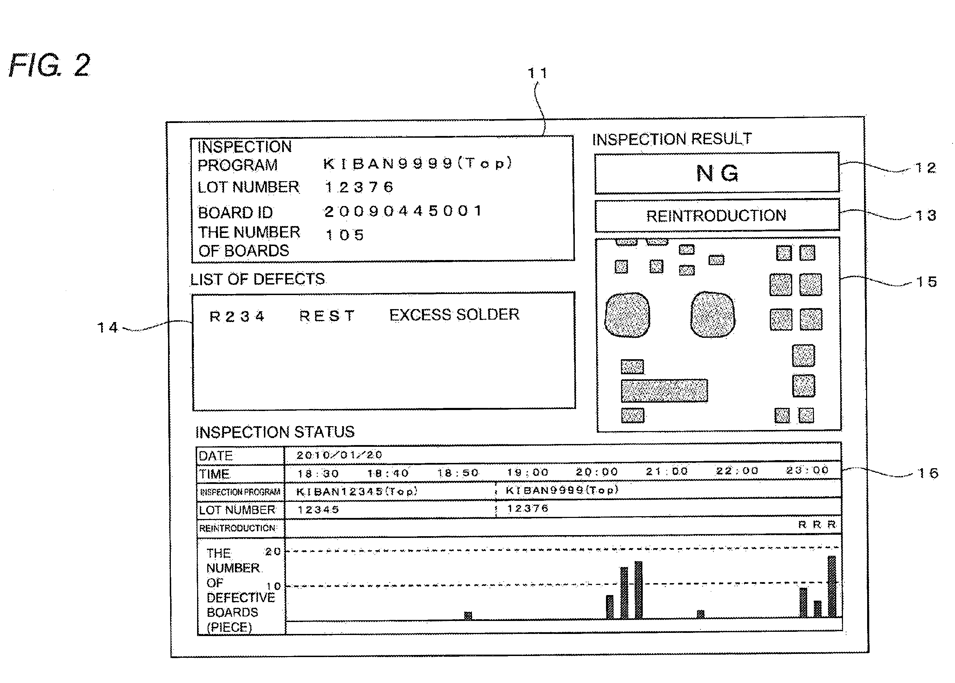

Fig. 2 illustrates an example of a screen displayed on the monitor 104. A plurality of display fields 11 to 16 are provided in the sample screen.
A type code of the inspection program in use, a lot number to which the inspection target board belongs, an identification code of the inspection target board (hereinafter referred to as the "board ID" according to the example illustrated in Fig. 2), and the number of boards in a lot are displayed as pieces of information on the current inspection target board in the display field 11 in an uppermost stage on the left of the screen.
The pieces of information except the board ID are selected or input by a user from previously-registered pieces of information. On the other hand, the main controller 101 reads the board ID that is marked on each board in the form of a barcode or a two-dimensional code.

The non-defective or defective determination result of the inspection target board is displayed in the display field 12 in an uppermost stage on the right of the screen. Specifically, "NG" is displayed as illustrated in Fig. 2 when the inspection target board is defective, and "OK" is displayed when the inspection target board is non-defective.

Whether the inspection target board is the reintroduced board that is extracted in the past is displayed in the display field 13 in a second stage on the right of the screen. In the embodiment, the determination whether the inspection target board is the reintroduced board is made immediately after the inspection target board is carried in to read the board ID, and the determination result is displayed by a character string of "reintroduction" or "non-reintroduction".
In the embodiment, when the determination that the inspection target board is the reintroduced board is made to display the character string of "reintroduction" on the display field 13, attention of the field person in charge is invited by lighting a predetermined color (for examples, yellow) in the pilot lamp 107.

A list of defective regions extracted from the inspection target board is displayed in the display field 14 in a second stage on the left of the screen. An image including the defective region is displayed in the display field 15 in a third stage on the right of the screen. For the image displayed in the display field 15, in response to a manipulation of the manipulation unit 110, display magnification can appropriately be changed or display target range can appropriately be switched.

A graph illustrating a change in quality of the inspected board is displayed in the display field 16 in a lowermost stage of the screen. Hereinafter the display field 16 is referred to as a "graph display field 16".
In the graph display field 16 of the embodiment, for the predetermined number of boards in the past, a bar graph in which the number of defective boards is arrayed in time series is displayed while correlated with pieces of information such as an inspection data, an inspection time, an inspection program, a lot number, and the presence or absence of the reintroduction. Each time the inspection of the inspection target board is ended, the data (oldest data) at left end of the graph is deleted, each piece of data moves leftward by one, and the data indicating the latest inspection result is added to a right end of the graph.

The graph displayed in the graph display field 16 is not limited to the bar graph, but a polygonal line graph may be used. The data edited in the graph, that is, the data indicating the board quality is not limited to the number of defective boards, but a percentage of total of a defective region or a non-defective region may be displayed as the data. An average value or a standard variation of a solder amount or a difference between a maximum value and a minimum value is fixed with respect to a land of a specific-number component having a large mounting number on each board, and the graph may be displayed using the these value.

In the embodiment, the field of "reintroduction" is provided immediately above the graph, and a letter "R" (abbreviation of "RETRY") is displayed in a position corresponding to the data of the reintroduced board. The letter "R" emerges at the same time as the inspection, of the reintroduced board is ended to add to the graph the data corresponding to the board, and the letter "R" is shifted by following the corresponding data when the graph is updated. Because the data corresponding to the reintroduced board is explicitly shown by the letter "R" in the graph, the field person in charge can easily recognize the quality when the board extracted in the past is reintroduced, and the field person in charge can determine whether or not productivity is improved by the reintroduction of the board.

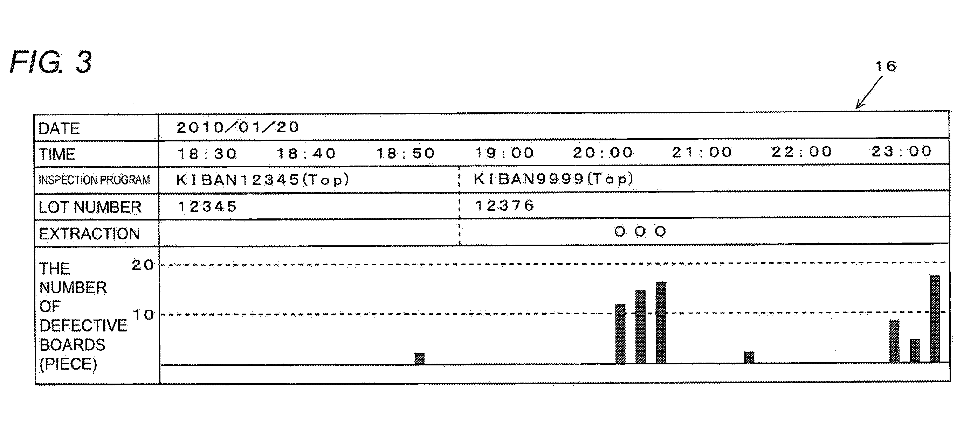

Figs. 3 to 5 are enlarged views each illustrating other display examples of the graph display field 16 in the screen displayed on the monitor 104. Each graph display field 16 has a basic configuration similar to that of Fig. 2. In the example of Fig, 3, a field of "extraction" is provided instead of the field of "reintroduction", and a letter "O" (abbreviation of "OUT') is displayed in a position corresponding to the data of the extracted board in the field.

The field person in charge determines whether or not the board is extracted when visually confirming the board that is determined to be defective by the solder printing inspection machine 100 (the board is extracted in the case where the field person in charge determines that the final product explicitly becomes defective when the board is delivered to a subsequent process). Accordingly, when the data corresponding to the extracted board is explicitly shown as illustrated in the example of Fig. 3, the field person in charge can easily confirm the quality of the extracted board to recognize whether the extraction determination is proper.

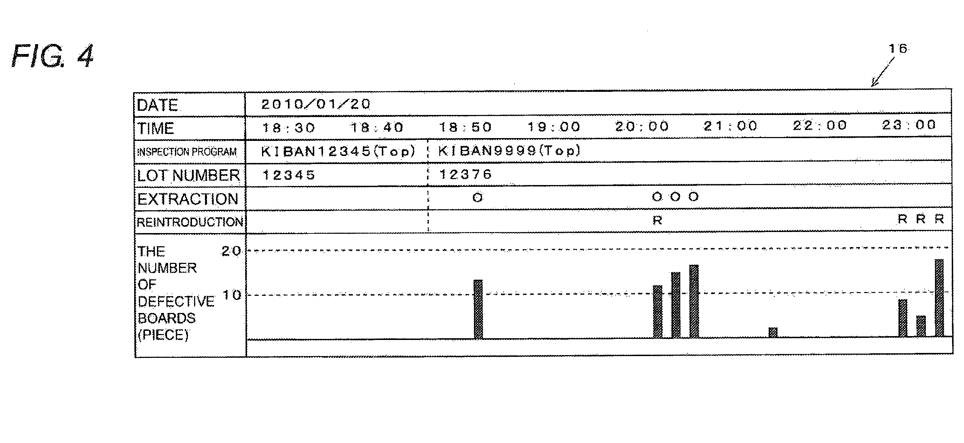

In the example of Fig. 4, the field of "extraction" and the field of "reintroduction" are provided in the graph display field 16. In the field of "extraction", the letter "O" is displayed in the position corresponding to the data of the extracted board. In the field of "reintroduction", the letter "R" is displayed in the position corresponding to the data of the reintroduced board.

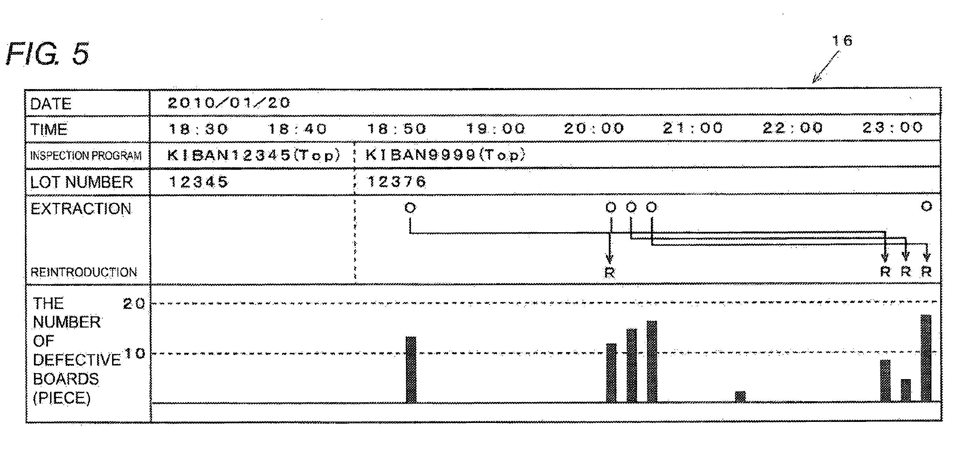

In the example of Fig. 5, similarly to the example of Fig. 4, the data of the extracted board and the data of the reintroduced board are displayed using the letter "O" and the letter "R". In the example of Fig. 5, the display fields of the letters "O" and "R" are integrated, and the letters corresponding to the identical board ID are connected by a line to express a correspondence relationship between the extraction and the reintroduction,

In the displays examples of Figs. 4 and 5, the field person in charge can confirm both the quality of the extracted board and the quality of the reintroduced board. When the reintroduced board or the board introduced immediately after the reintroduced board is extracted, the field person in charge can instantly recognize a causal relationship between the reintroduction and the extraction from the relationship between the letter "R" and letter "O", which are added to the data corresponding to the reintroduced board or the board introduced immediately after the reintroduced board.

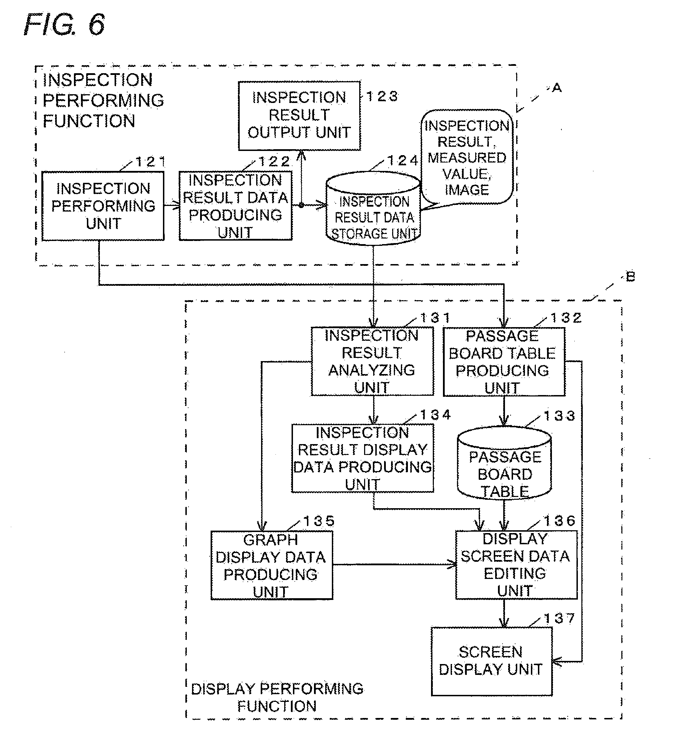

Fig. 6 illustrates functions provided in a control system (main controller 101 and sub-controller 102 of Fig. 1) of the solder printing inspection machine 100, The functions provided in the control system of the embodiment are classified into a function A relating to the inspection performance and a function B of performing the display illustrated in Figs. 2 to 5.

The inspection performing function A includes an inspection performing unit 121, an inspection result data producing unit 122, an inspection result output unit 123, and an inspection result data storage unit 124. The inspection performing unit 121 performs a series of control relating to the inspection based on the set inspection program. The inspection performing unit 121 also performs processing of reading the board ID marked on the inspection target board prior to the inspection.

The inspection result data producing unit 122 collects the measured values of the inspection areas or determination results into one data file to set the board ID and inspection time of the inspection target board to the file name and an attribute of the data file, and the inspection result data producing unit 122 stores the data file in the inspection result data storage unit 124. The inspection result data producing unit 122 stores a file of an image used in the board inspection in the inspection result data storage unit 124 in each inspection target board while the file name including the board ID of the board is added to the image file.
The inspection result output unit 123 performs processing of transmitting the inspection result data produced by the inspection result data producing unit 122 to the external device.

The display performing function B includes an inspection result analyzing unit 131, a passage board table producing unit 132, a passage board table 133, an inspection result display data producing unit 134, a graph display data producing unit 135, a display screen data editing unit 136, and a screen display unit 137.

The passage board table producing unit 132 receives the inspection time and board ID of the inspection target board from the inspection performing unit 121 to register the inspection time and the board ID in the passage board table 133. In registering the inspection time and the board ID in the passage board table 133, the passage board table producing unit 132 determines whether or not the inspection target board is the reintroduced board using the board ID, and the passage board table producing unit 132 registers the recognition result in the passage board table 133. When the letter "O" indicating the extraction is displayed in the graph display field 16 as illustrated in the examples of Figs. 3 to 5, the data indicating the presence or absence of the board extraction is registered in the passage board table 133 in each board.

The inspection result analyzing unit 131 reads the inspection result data and the board image data from the inspection result data storage unit 124 to derive the data indicating the board quality through statistical processing in which the measured data in the inspection result data is used. The inspection result analyzing unit 131 provides the derived data and the read data to the inspection result display data producing unit 134 and the graph display data producing unit 135.
The inspection result display data producing unit 134 produces the pieces of data displayed in the display fields 11, 12, 14, and 15 using the provided pieces of data. The graph display data producing unit 135 produces the pieces of data (except the letters "R" and "O") displayed in the graph display field 16,
As described above, for example, the number of defective boards, a percentage of the defective region or non-defective region, and the value in which the measured values of pieces of cream solder are statistically processed in each component number can be used as the data indicating the board quality.

The display screen data editing unit 136 edits the image data for the confirmation screen illustrated in Fig. 2 using the pieces of display data produced by the inspection result display data producing unit 134 and the graph display data producing unit 135 and the information stored in the passage board table 133, At this point, the display screen data editing unit 136 refers to the passage board table 133 specify the target data to which the letter "R" or "O" is added from the pieces of data expressed in the graph, and the display screen data editing unit 136 performs processing of adding the display data of the letter "R" or "O" to the image data of the display screen. A function of performing the displays to the display field 13 in receiving the inspection target board is also provided in the display screen data editing unit 136.
The screen display unit 137 receives the image data from the display screen data editing unit 136 to display the image data on the monitor 104. Therefore, the screen having the form illustrate in Fig. 2 is displayed on the monitor 104.

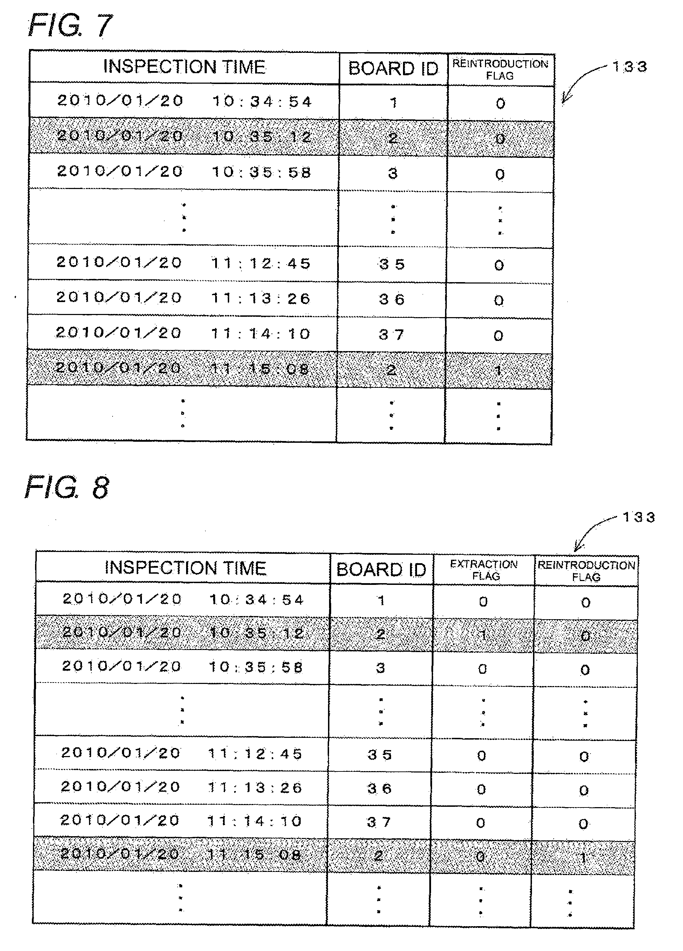

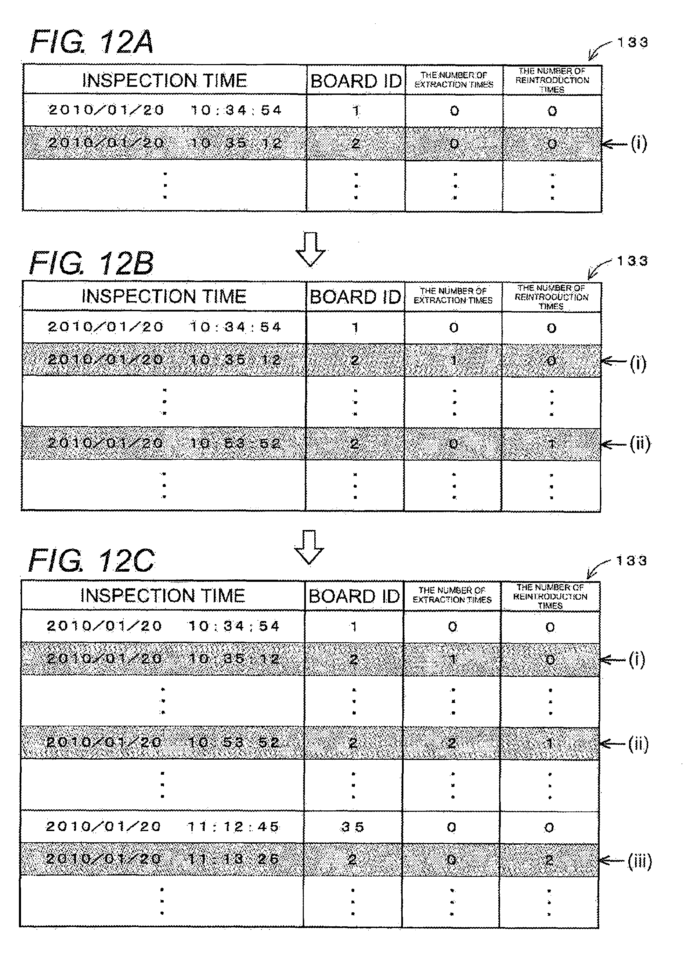

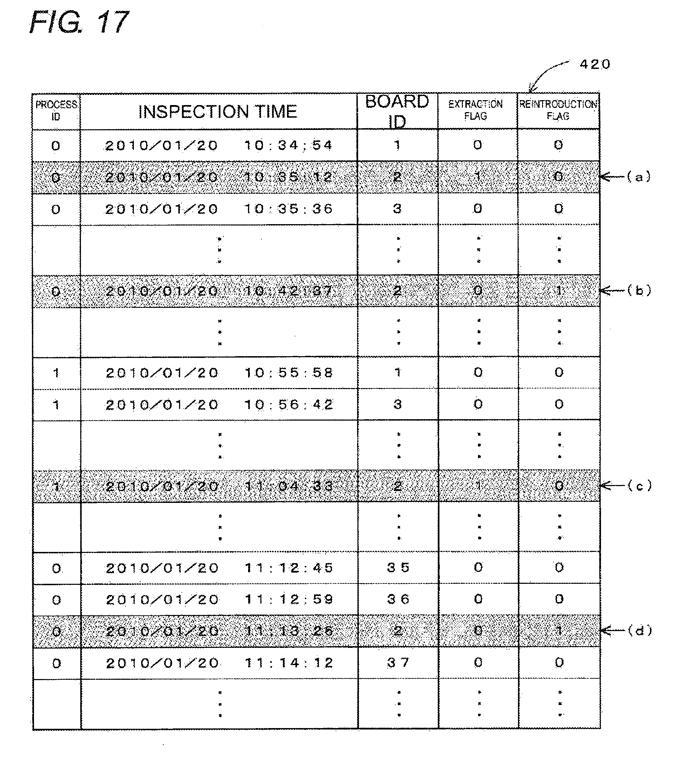

Fig. 7 illustrates an example of a data configuration of the passage board table 133. In Fig. 7, Fig. 8. Figs. 12A to 12C. and Fig. 17, the board ID of each board is expressed by one-or two-digit number for the sake of convenience.

In the example of Fig. 7, the inspection time, the board ID, and a flag (hereinafter referred to as a "reintroduction flag") indicating the presence of absence of the reintroduction are registered in passage board table 133 in each inspected board, In entries (pieces of registered information) of the passage board table 133, the entry whose reintroduction flag is set to "0" means that the corresponding board is not the reintroduced boards, and the entry whose reintroduction flag is set to "1" means that the corresponding board is the reintroduced board extracted in the past.

The inspection time registered in the passage board table 133 corresponds to a time the inspection performing unit 121 reads the board ID to start the inspection. Alternatively, an inspection ending time or both an inspection starting time and the inspection ending time may be registered. The time is not registered, but a number indicating the inspection order of each board may be registered.

After receiving the board ID and inspection time of the new inspection target board from the inspection performing unit 121, the passage board table producing unit 132 sequentially focuses attention on the entries of the passage board table 133 in a retroactive manner, and searches the entry including the board ID identical to that of the inspection target board. When the entry including the board ID identical to that of the inspection target board is found, the board corresponding to the entry corresponds to the board that is extracted due to the defect, and the inspection target board is determined to be the board in which the extracted board is reintroduced. The reintroduction flag of the inspection target board is set to "1", and the inspection time, board ID, and reintroduction flag of the board are registered in the passage board table 133.

In Fig. 7, the entries corresponding to the extracted board and reintroduced board are expressed by hatching, When the board is reintroduced, it can be recognized from the entries expressed by hatching that the board is reproduced at 11:15:08 after the board inspected at 10:35:12 is extracted due to the defect.

The passage board table 133 of Fig. 7 is used when only the letter "R" is displayed in the graph display field 16. On the other hand, when the letter "O" indicating the extraction is displayed in the graph displays field 16 as illustrated in the examples of Figs. 3 to 5, the passage board table 133 has a configuration illustrated in Fig. 8.

In the example of Fig. 8, not only the inspection time, board ID, and reintroduction flag of the board are registered similarly to the example of Fig. 7, but also a flag indicating the presence or absence of the extraction (hereinafter referred to as an "extraction flag") is registered in the passage board table 133. The entry in which the extraction flag is set to "0" means that the corresponding board is delivered to the subsequent component mounting process without the extraction, and the registered information in which the extraction flag is set to "1" means that the corresponding board is extracted.

Hereinafter the processing relating to the display of the inspection result will be described in detail, assuming that the passage board table 133 having the configuration of Fig. 8 is produced and the data corresponding to the extracted board and the data corresponding to the reintroduced board are explicitly shown in the graph display field 16 by the letters "O" and "R".

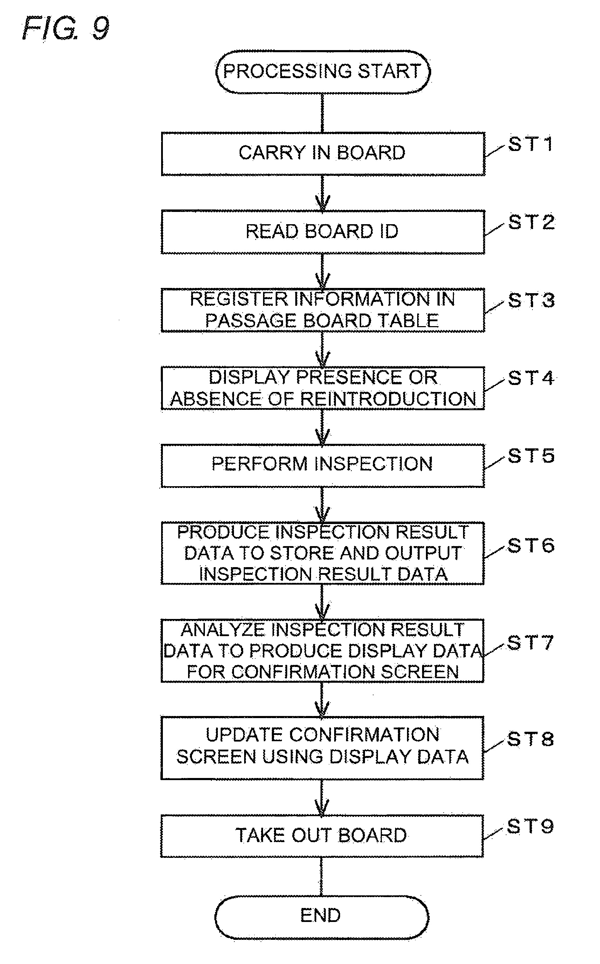

Fig. 9 is a flowchart illustrating processing performed to one inspection target board in the solder printing inspection machine 100. The schematic procedure of the inspection will be described with reference to the symbols of the steps of flowchart of Fig. 9.
The inspection target board is carried in (ST1), and processing of reading the board ID that is marked as the barcode or two-dimensional code on the board is performed (ST2). The pieces of processing in steps ST1 and ST2 are performed by the inspection performing unit 121 of Fig. 6.

Processing of registering the information on the inspection target board in the passage board table 133 is performed (ST3), The processing in step ST3 is performed by the passage board table producing unit 132.

After step ST3, the presence or absence of the reintroduction is displayed in the display field 13 based on the reintroduction flag registered in the passage board table 133 (ST4). The processing in step ST4 is performed by the display screen data editing unit 136 that detects the update of the passage board table 133.

Then the inspection performing unit 121 performs the inspection to the inspection target board (ST5). After the inspection, the inspection result data producing unit 122 produces the above-described inspection result data to store the inspection result data in the inspection result data storage unit 124. The inspection result data producing unit 122 performs processing of outputting the inspection result data to the external device (ST6).

Then the inspection result analyzing unit 131, the inspection result display data producing unit 134, the graph display data producing unit 135, and the display screen data editing unit 136 jointly process the pieces of information in the inspection result data storage unit 124 and passage board table producing unit 132 to produce the display data of the confirmation screen (ST7). The screen display unit 137 updates the confirmation screen on the monitor 104 using the display data (ST8).
The inspection target board is taken out (ST9), and then the processing is ended.

In the confirmation screen of Fig. 2, the display in the display field 13 is performed in step ST4, and the pieces of displays data in other display fields are produced in step ST7. The board ID in the displays field 11, the list of defects in the display field 14, and the inspection results in the display field 12 are read from the inspection result data of the inspection target board. The image of the inspection target board in the display field 15 is read from the image file stored in the inspection result data storage unit 124.

The pieces of data constituting the graph in the graph display field 16 are bundled with the board ID of the corresponding board. Therefore, as to the display of the letter "R", the data to which the letter "R" is added can be specified from the pieces of data in the graph based on the board ID of the entry in which the reintroduction flag in the passage board table 133 is set to "1". Similarly, as to the display of the letter"O", the data to which the letter "0" is added can be specified based on the board ID of the entry in which the extraction flag in the passage board table 133 is set to "1"

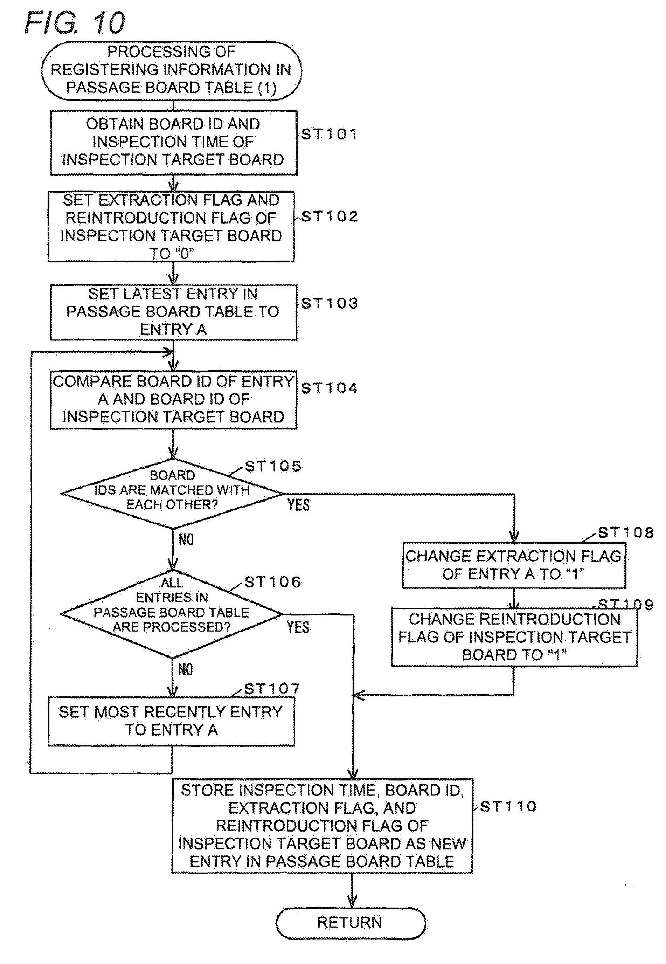

The processing in step ST3 performed by the passage board table producing unit 132 will be described in detail with reference to Fig. 10.
In the embodiment, although not illustrated in Fig. 10, the boards processed within a given period (for example, one day) are registered in the passage board table 133 of the embodiment, and the registered boards are cleared with every given period.

The passage board table producing unit 132 receives the board ID and inspection time of the inspection target board from the inspection performing unit 121 (ST101).
The passage board table producing unit 132 sets initial values of the extraction flag and reintroduction flag of the inspection target board to "0" (ST102). The passage board table producing unit 332 sets the latest entry (entry of the most recently inspected board) in the passage board table 133 to an entry A of a checkup target (ST103), and the flow goes to a loop of ST104 to ST107.

In the loop, processing of comparing the board ID of the entry A and the board ID of the inspection target board is sequentially repeated in a retroactive manner while the entry A is changed until the board ID of the entry A is matched with the board ID of the inspection target board. When the entry A whose board ID is matched with the board ID of the inspection target board cannot be found even if the inspection target board is checked up against all the entries in the passage board table 133 ("YES" in ST106), the inspection time, board ID, extraction flag, and reintroduction flag of the inspection target board are stored as a new entry in passage board table 133 (ST107).

On the other hand, when the board ID of the checkup target entry A is matched with the board ID of the inspection target board in the loop of ST104 to ST107 ("YES" in ST105), the flows is out of the loop of ST1 04 to ST107, the extraction flag of the entry A is changed to "1" (ST108). Then the reintroduction flag of the inspection target board is changed to "1" (ST109), the inspection time, board ID, extraction flag, and reproduction flag of the inspection target board are stored as a new entry in the passage board table 133 (ST110)

According to the procedure, in the stage in which the board is extracted, the entry whose extraction flag is set to "1" cannot be set to the board. However, when the extracted board is reintroduced, the entry whose reintroduction flag is set to "1" is automatical registered with respect to the board, and processing of rewriting the extraction flag of the entry registered in extracting the board from "0" to "1" can automatically be performed. Therefore, when the inspection of the reintroduced board is ended to update the graph display field 16 on the monitor 104 based on the inspection results, the data of the reintroduced board is added while explicitly shown by the letter "R", and the data indicating the inspection result in extracting the board is explicitly shown by the letter "O".

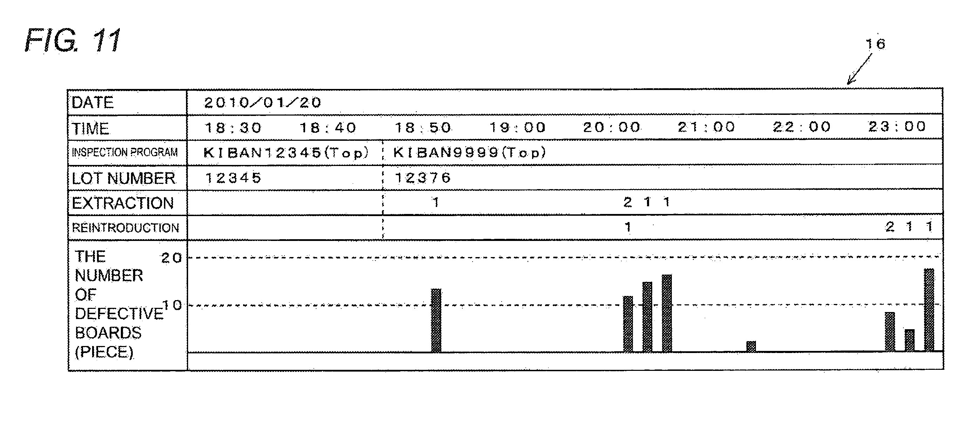

In the display examples of the graphs illustrated in Figs. 4 and 5, the data corresponding to the extracted board and the data corresponding to the reintroduced board are explicitly shown by the letters '"O" and "R". Alternatively, four colors: a color expressing the data of the extracted board; a color expressing the data of the reintroduced board; a color expressing data of the board in which both the reintroduction and the extraction are generated; and a color expressing the data of the board that does not become the extraction or reintroduction target are set as display colors of the graph, and the pieces of data may be displayed while classified in colors.
As illustrated in Fig. 11, the data of the extracted board and the data of the reintroduced board may explicitly be shown by the number of extraction times and the number of reintroduction times.

Figs. 12A to 12C illustrate a configuration of the passage board table 133 used to display the example of Fig. 11. In the passage board table 133 of the embodiment, the number of extraction times and the number of reintroduction times are registered instead of the extraction flag and the reintroduction flag.

In Figs. 12A to 12C, assuming that the board having the board ID of "2" is introduced three times, the number of extraction times and the number of reintroduction times change in the progress of processing in an entry (i) produced in the first-time introduction, an entry (ii) produced in the second-time introduction, and an entry (iii) produced in the third-time introduction.

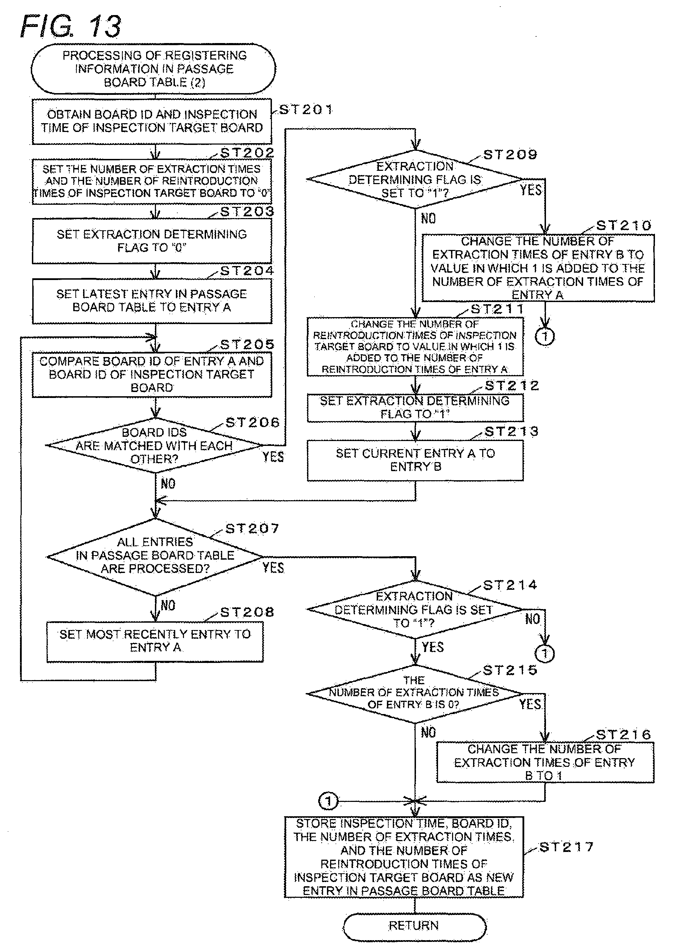

Fig. 13 illustrates a procedure of processing (corresponding to ST3 of Fig. 9) performed in displaying the example of Fig. 11 by the passage board table producing unit 132.

In the embodiment, the passage board table producing unit 132 obtains the board ID and inspection time of the inspection target board from the inspection performing unit 121 (ST201). The passage board table producing unit 132 sets the number of extraction times and the number of reintroduction times of the inspection target board to the initial value of "0" (ST202), and sets the extraction determining flag to "0" (ST203),
The extraction determining flag indicates whether or not the inspection target board is determined to be the board extracted in the past, and the extraction determining flag differs from the extraction flag of the embodiment of Fig. 10 in a concept.

The passage board table producing unit 132 sets the latest entry (entry of the most recently inspected board) in the passage board table 133 to the entry A of the checkup target (ST204), and the flow goes to a loop of ST205 to ST208.
In the loop, similarly to the loop of ST104 to ST107 of Fig. 10, the processing of comparing the board ID of the entry A and the board ID of the inspection target board is sequentially repeated in the retroactive manner while the entry A is changed until the board ID of the entry A is matched with the board ID of the inspection target board. When the entry A whose board ID is matched with the board ID of the inspection target board cannot be found even if all the entries are processed ("YES" in ST207), because the extraction determining flag remains in the initial setting of "0" ("NO" in ST214), the flow goes to step ST217, and the inspection time, board ID, the number of extraction times, and the number of reintroduction times of the inspection target board are stored as a new entry in passage board table 133 (ST217). At this point, both the number of extraction times and the number of reintroduction times are set to "0"

On the other hand, when the board ID of the entry A is matched with the board ID of the inspection target board ("YES" in ST206), the flow goes to step ST209 to check the extraction determining flag. At this point, when the extraction determining flag is set to "0" ("NO" in ST209), the number of reintroduction times of the inspection target board is changed to a value in which "1" is added to the number of reintroduction times of the entry A (ST211). The extraction determining flag is set to "1" (ST212), and the current entry A is changed to an entry B (ST213).

After step ST213 is performed, the flow returns to the loop of set205 to ST208 to search the entry whose board ID is matched with that of the inspection target board. When the entry whose board ID is matched with that of the inspection target board is found ("YES" in ST206), the extraction determining flag is checked again in step ST209, At this point, because the extraction determining flag is set to "'1", the flow goes from ST209 to ST210, and the number of extraction times of the entry B is changed to a value in which 1 is added to the number of extraction times of the entry A.
Then the flow goes to step ST217, and the inspection time, board ID, the number of extraction times, and the number of reintroduction times of the inspection target board is stored as a new entry in the passage board table 133.

When all the entries in the passage board table 133 are processed in the loop of ST205 to ST208 ("YES" in ST207), and when the extraction determining flag is set to "1" ("YES" in ST214), the number of extraction times of the entry B is checked (ST215). When the number of extraction times of the entry B is set to "0" ("YES" in ST215), the number of extraction times of the entry B is changed to 1 (ST216), and the processing in step ST217 is performed. On the other hand, when the number of extraction times of the entry B is more than 0 ("NO" in ST215), the flow goes to step ST217 without performing the processing in step ST216,

A specific processing flow is organized in each case when the registration processing is performed to the passage board table 133 based on the procedure of Fig. 13 while the board illustrated in Figs. 12A to 12C having the board ID of "2" is used as the inspection target.

### (First-Time Processing)

The entry whose board ID is matched with that of the inspection target board does not exist in the passage board table 133 when the board having the board ID of "2" is initially processed. Therefore, after the pieces of processing in step ST201 to ST204 are performed, the entry whose board ID is matched with that of the inspection target board cannot be found, the decision in step ST207 becomes affirmative while the number of extraction times, the number of reintroduction times, and the extraction determining flag remain in the initial setting state, and the loop of ST205 to ST208 is ended. Then the decision in step ST214 becomes negative to perform the processing in step ST217.
Therefore, as illustrated in Fig. 12A, both the number of extraction times and the number of reintroduction times becomes 0 in the entry (i) registered in the passage board table 133 at this point.

### (Second-Time Processing)

When the board to which the first-time processing is performed is extracted and reintroduced, the flow goes to the loop of ST205 to ST208 after the pieces of processing in steps ST201 to ST204 are performed. At this point, when the entry (i) is set to the entry A, the board ID of the entry A is matched with the board ID of the inspection target board, and the decision in step ST206 becomes affirmative. Therefore, the flow goes to step ST209 to check the extraction determining flag, Because the extraction determining flag is set to "0", the decision in step ST209 becomes negative to perform the pieces of processing in steps ST211 to ST213.

As a result, the number of reintroduction times of the inspection target board is changed from 0 to 1, and the extraction determining flag is changed to "1". The entry (i) is set to the entry B.
Then the flow returns to the loop of ST205 to ST208 to search the entry whose board ID is matched with that of the inspection target board. However, because the corresponding entry is not found any more, the decision in step ST207 finally becomes affirmative, and the flow goes to step ST214. At this point, because the extraction determining flag is set to "1", the decision in step ST214 becomes affirmative, and the flow goes to step ST215. Because the number of extraction times of the entry (i) set to the entry B is 0, the decision in step ST215 becomes affirmative, and the flow goes to step ST216. Therefore, as illustrated in Fig. 12B, the number of extraction times of the entry (i) is changed to 1,

The processing in step ST217 is performed after the number of extraction times is changed. Therefore, the entry (ii), in which the number of extraction times is 0 and the number of reintroduction times is 1, is set with respect to the inspection target board and registered in the passage board table 133.

### (Third-Time Processing)

When the reintroduced board is extracted again and reintroduced, the flow goes to the loop of ST205 to ST208 after the pieces of processing in steps ST201 to ST204 are performed. At this point, when the entry (ii) is set to the entry A, because the board ID of the entry A is matched with the board ID of the inspection target board, the flow goes from step ST206 to step ST209 to check the extraction determining flag. Because the extraction determining flag is set to "0", the decision in step ST209 becomes negative to perform the pieces of processing in steps ST21 to ST213.

As a result, the number of reintroduction times of the inspection target board is set to 2, the extraction determining flag is set to "1", and the entry (ii) is changed to the entry B.
The flow returns to the steps ST205 to ST208 to search the entry whose board ID is matched with that of the inspection target board. At this point, when the entry (i) is set to the entry A, the decision in step ST206 becomes affirmative, and the flow goes to step ST209 to check the extraction determining flag again. At this point, because the extraction determining flag is set to "1", the decision in step ST209 becomes affirmative to perform the processing in step ST210.

Therefore, as illustrated in Fig. 12C, the number of extraction times of the entry (ii) set to the entry B is changed to a value in which 1 is added to the number of extraction times of the entry (i) set to the entry A, that is, 2. Then the entry (iii), in which the number of extraction times is 0 and the number of reintroduction times is 2. is set by performing the processing in step ST217 and stored in the passage board table 133.

As described above, when the extraction or the reintroduction of the board is generated at least twice, the number of reintroduction times of the board is obtained by the processing at the time the board is reintroduced, and the number of extraction times can be obtained at the time most recently extraction is generated. Therefore, in the graph display field 16, the data of the reintroduced board is added while explicitly shown by the number of reintroduction times, and the number of extraction times of the data of the extracted board is updated.

Fig. 14 illustrates an example in which a system M that manages the quality of the produced board is introduced to a board production line L including the solder printing inspection machine 100.
A solder printer 1 a component mounting machine 2, and a reflow furnace 3 are provided as production facilities in the board production line L. The solder printing inspection, machine 100 is provided in the subsequent stage of the solder printer 1, a component mounting inspection machine 200 is provided in the subsequent stage of the component mounting machine 2, and an inspection machine 300 for final inspection is provided in the subsequent stage of the reflow furnace 3.
The detailed configuration of the solder printing inspection machine 100 is already illustrated in Fig. 1. The basic configurations of the inspection machine 200 and 300 are similar to the basic configuration of the inspection machine 100.

The quality management system M is formed as a computer network system in which a server 4 and terminal devices 5 (although Fig. 14 illustrates three terminal devices 5A. 5B, and 5C, the number of terminal devices is not limited three) used by the person in charge of each section are connected through an intranet. The server 4 is also connected to the production facilities 1, 2, and 3 and the inspection machines 100, 200, and 300 of the board production line L through dedicated line Z.

Based on previously set operation definition, each the production facilities 1, 2, and 3 transmits information indicating the production condition in performing the processing to the board to the server 4 along with the board ID of the board each time one board is processed.
The production condition depends on the process. For example, the solder printer 1 transmits the pieces of information such as a setting value rotating to a thickness of the processing target board, a pressure applied to the squeeze in transferring the solder (printing pressure), a time to start the processing of the next board after the processing of one board is ended (processing interval), and work performed to the solder printer 1.

Each of the inspection machines 100, 200, and 300 in turn receives the board processed by each of the production facilities 1, 2, and 3 in the preceding stage and performs the inspection to produce the inspection result data file in each board. The file name and attribute of the data file include the board ID and inspection time of the inspection target board. Each of the inspection result data files is stored in a memory of each of the inspection machines 100, 200, and 300 that perform the inspection, and the inspection result data file is transmitted to the server 4.

The server 4 stores the information, transmitted from each of the production facilities 1, 2, and 3 or the inspection machines 100, 200, and 300, in an internal memory while the information is read using the board ID or an identification code of the process of the source facility (hereinafter referred to as a "process ID") as a key.
In the production management system M of the embodiment, each terminal device 5 receives the manipulation to assign the analytical target board group or the process, and the terminal device 5 transmits the assigned content to the server 4. In response to the transmission from the terminal device 5, the server 4 performs various pieces of analytical processing based on the information that is transmitted from the production facility or inspection machine in the process assigned with respect to an assigned board group, and the server 4 sends back the confirmation screen display data of the analytical result to the terminal device 5. The terminal device 5 starts up the confirmation screen on a monitor thereof based on the transmitted information. For example, the analytical target board group is assigned by the lot number or a time slot of the processing.

Among the pieces of analytical processing, the data indicating the quality of each board in the board group and the production condition at the time the solder printer 1 processes the board are derived in the analytical processing for the solder printing process. Additionaly, in the analytical processing for the solder printing process, the board that is extracted due to the noticeable defect or the board that is reintroduced after the extraction is specified from the analytical target boards, and the display is performed such that the relationship between the specified board and the analytical result can easily be recognized.

Fig. 5 illustrates an example of the confirmation screen of the analytical processing result aimed at the solder printing process.
In the embodiment, the plurality of boards belonging to the identical lot are collectively assigned by the lot number, and processing of individually analyzing each assigned board and processing of integrally analyzing the inspection results of the boards are performed.

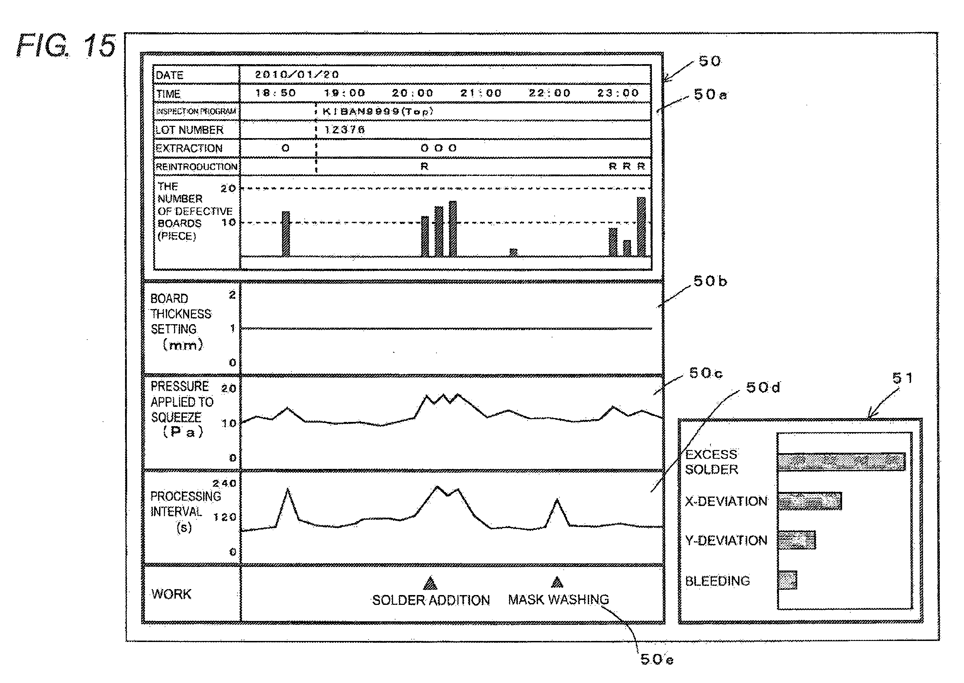

In Fig. 15, an area 50 on the left of the screen expresses the analytical result of the individual board, and five display fields 50a to 50e are vertical arrayed in the area 50. A graph in which the numbers of defective boards are arrayed in time series is displayed in the uppermost display field 50a. The display of the graph is based on the inspection result data of each board, which is transmitted from the solder printing inspection machine 100, and the pieces of data such as the inspection performing data and time, the program, the lot number, the extraction, and the reintroduction are correlated similarly to the graph of Fig. 4.

The displays in the display fields 50b to 50e are based on the production conditions transmitted from the solder printer 1. A setting value (unit is milimeter) of a thickness of the board is displayed in the form of time-series graph in the display field 50b. A pressure applied to the squeeze (unit is pascal) is displayed in the form of time-series graph in the displays field 50c. A time length (unit is second) between the pieces of processing performed to the boards is displayed in the form of time-series graph in the display field 50d.
Text data indicating contents of the work performed to the solder printer 1 is displayed in a lowermost display field 50e along with a mark "▲" expressing timing of the work.

In the uppermost display field 50a, similarly to the display example of the solder printer 100, the bar graph in which the number of defective boards is arrayed in time series is displayed, the data of the extracted board is explicitly shown by the letter "O", and the data of the reintroduced board is explicitly shown by the letter "R".

The graphs and the mark displays in the display fields 50a to 50e are adjusted such that the pieces of data corresponding to the identical board are vertically arrayed in line based on the board ID bundled with the original data (inspection result data and production condition data).
The graph in which a frequency of the defect detected in the analytical target boards is collected in each defect type is displayed in a display area 51 on the right of the screen,

According to the display of Fig. 15, the user of the terminal device 5 in which the display is performed can recognize the quality of the extracted board or the reintroduced board from the display in the display field 50a, and the user can recognize the production conditions at the time the board is extracted from the relationship between the displays in the display fields 50b to 50e and the letter "O", The user can also recognize the defect having a high occurrence frequency from the graph in the area 51, so that the user can determine the cause of the board extraction based on the recognition results.

Fig, 16 illustrates functions that are provided in the server 4 of the production management system M in order to perform the display of Fig. 15.

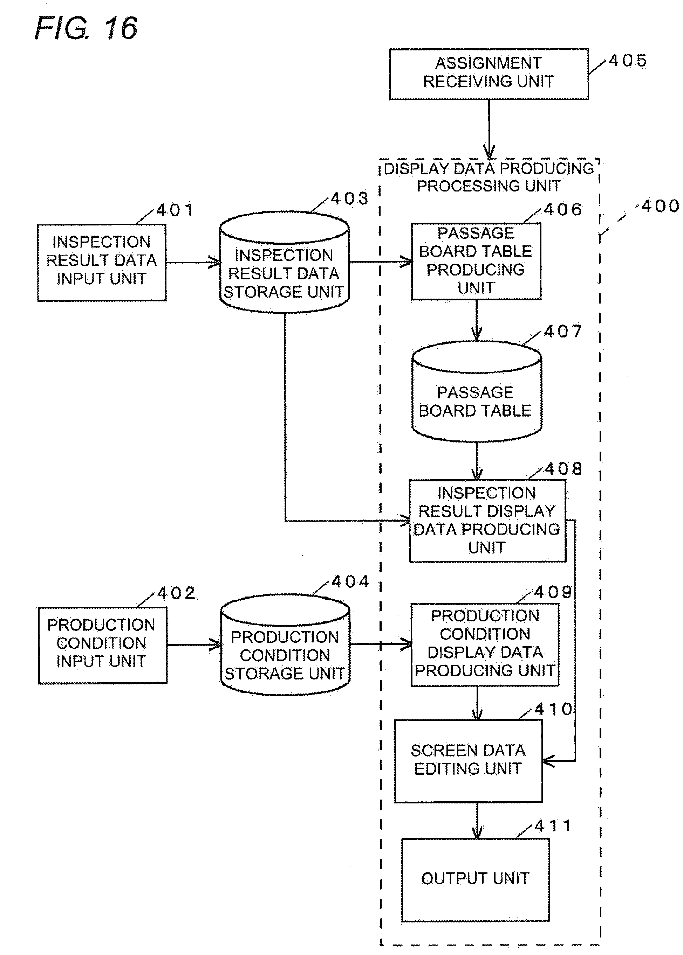

In Fig. 16, an inspection result data input unit 401 receives the inspection result data transmitted from the solder printing inspection machine 100 and stores the inspection result data in an inspection result data storage unit 403. A production condition input unit 402 receives information indicating the production conditions, which is transmitted from the solder printer 1, and accumulates the information in a production condition storage unit 404. The board ID and processing time of the corresponding board are added to the information stored in each of the storage units 403 and 404.

An assignment receiving unit 405 illustrated in Fig. 16 receives assignment content, which is transmitted from the terminal device 5 that receives the assignment of the analytical target.
Based on the information transmitted from the assignment receiving unit 405 that receives the assignment content, a display data producing processing unit 400 produces display data corresponding to the assignment to transmit the display data to the terminal device 5. The display data producing processing unit 400 includes a passage board table producing unit 406, a passage board table 407, an inspection result displays data producing unit 408, a production condition display data producing unit 409, a screen data editing unit 410, and an output unit 411.

Based on the inspection result data stored in the inspection results data storage unit 403, the passage board table producing unit 406 sets the boards included in the analytical target board group to the processing target in the chronological order, and the passage board table producing unit 406 registers the pieces of data, such as the board ID, inspection time, extraction flag, and reintroduction flag of the processing target board in the passage board table 407. Specifically, the entry whose board ID is identical to that of the processing target board is searched in the retroactive manner from the entries that is registered in passage board table prior to the processing target board by an algorithm similar to that of Fig. 10. When the corresponding entry is found, the extraction flag of the entry is set to "1", and the reintroduction flag of the processing target board is set to "1".

The inspection result display data producing unit 408 reads the inspection result data of the analytical target board in the analytical target process from the inspection result data storage unit 403 to produce the data displayed in the display field 50a using the inspection result data. As to the displays of the fields of "extraction" and "reintroduction" in the display field 50a, the inspection result display data producing unit 408 refers to the passage board table 407 to specify the extracted board and the reintroduced board from the board ID, and the inspection result displays data producing unit 408 adjusts the relationship between the letters and the graph such that the letter "O" is disposed in the position corresponding to the data of the extracted board in the graph and such that the letter "R" is disposed in the position corresponding to the data of the reintroduced board.

The inspection result display data producing unit 408 also counts the number of defects detected in the analytical target boards in each defect type and produces the data displayed in the display area 51 based on the count values.

The production condition display data producing unit 409 reads the production conditions of each analytical target board from the production condition storage unit 404 and analyzes the type of the production conditions to produce the display data in each of the display fields 50b to 50e.

The screen data editing unit 410 edits the confirmation screen image data using various pieces of display data produced by the inspection result displays data producing unit 408 and the production condition display data producing unit 409. The output unit 411 transmits the completed image data to the terminal device 5 that transmits the assignment content.

According to the production management system M, the person in charge of analysis, who uses the terminal device 5, selects the analytical target board group to assign the analysis of the solder printing process, which allows the confirmation screen of Fig. 15 to be displayed on the monitor of the terminal device 5, In the confirmation screen, the graph indicating the quality of each board and the graphs indicating the production conditions are displayed in time series while correlated with one another, and the data of the extracted board and the data of the reintroduced board are explicitly shown, so that the person in charge can properly and easily perform the various pieces of analytical work.
For example, a determination whether or not the reuse of the extracted board lowers the productivity can be made by confirming the quality of the reintroduced board or the occurrence frequency of the extraction or reintroduction. The cause of the defect can be specified to plan a policy to eliminate the cause by confirming the production conditions at the time the extraction is generated.

The algorithms illustrated in Figs. 10 and 13 are constructed on the assumption that all the boards reintroduced to the solder printing process are extracted in the solder printing process. However, depending on the site, sometimes the board is extracted when the mounting defect is generated in the component mounting process, and the component and solder are removed to reintroduce the board to the solder printing process. In such cases, when the registration processing is performed to the passage board table by the procedures illustrated in Figs. 10 and 14, the board extracted in the component mounting process is mistakenly recognized as the board extracted in the solder printing process, and therefore the cause of the extraction cannot correctly be recognized. Therefore, in such cases, it is necessary to check the board passage state in the component mounting process in addition to the solder printing process.

Fig. 17 illustrates a configuration example of the passage board table 420 applied in extracting the defective board in both the solder printing process and the component mounting process. The passage board table 420 is stored in the server 4 of the production management system M illustrated in Fig. 14. The information based on the inspection result data from the solder printing process and the information based on the inspection result data from the component mounting process are registered in the passage board table 420. Each entry includes the identification code (process ID) of the process in which the process is performed in addition to the inspection time, the board ID, the extraction flag, and the reintroduction flag. The entry having the process ID of "0" indicates that the corresponding board is processed in the solder printing process, and the entry having the process ID of "1" indicates that the corresponding board is processed in the component mounting process.

In Fig. 17, the entry is set to the passage board table 420 of the embodiment in the temporal order in which each of the inspection machines 100 and 200 in the processes receives the board. An entry (a) of Fig. 17 is set when the board having the board ID of "2" is initially introduced to the solder printing process, an entry (b) is set when the board is reintroduced to the solder printing process after extracted. An entry (c) is set when the reintroduction board is guided to the component mounting process, and an entry (d) is set when the board extracted in the component mounting process is reintroduced to the solder printing process.

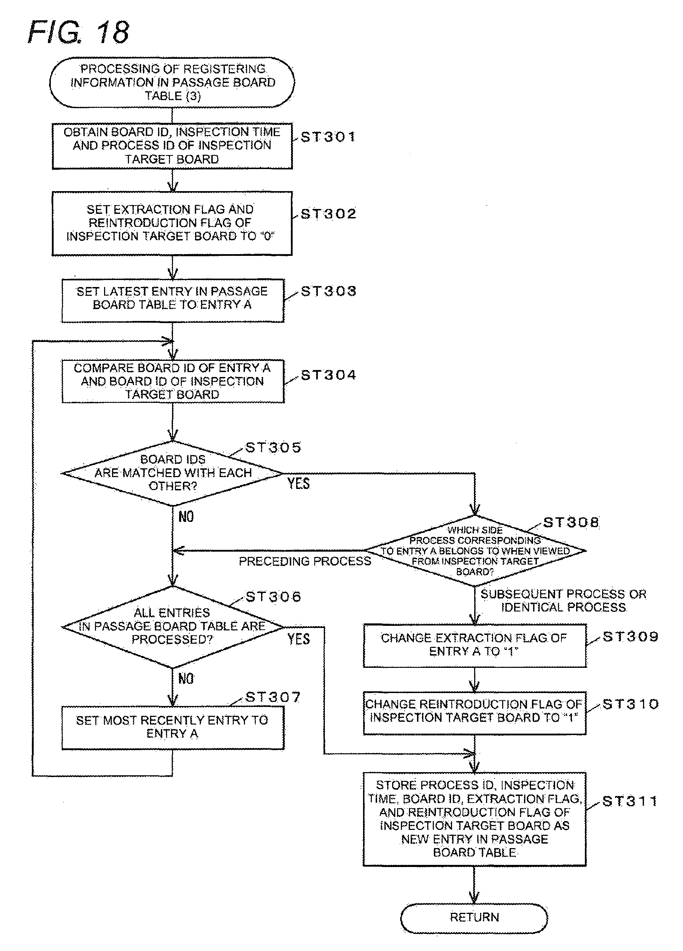

When the confirmation screen of Fig. 2 is displayed in the solder printing inspection machine 100 using the passage board table 420 having the configuration of Fig 17, the server 4 performs registration processing to the passage board table 420 based on the pieces of inspection result data transmitted from the solder printing inspection machine 100 and the component mounting inspection machine 200. Fig. 18 illustrates a procedure of the registration processing.

The procedure of the registration processing will be described below with reference to the symbols of the steps in Fig. 18.
The registration processing is started in response to the inspection result data transmitted from the solder printing inspection machine 100 or component mounting inspection machine 200. The board ID and inspection time of the inspection target board are obtained from the received inspection result data, and the process ID of the machine that is of the source of the inspection result data is also obtained (ST301). The extraction flag and reintroduction flag of the inspection target board are initially set to "0" (ST302). The latest entry in the passage board table 420 is set to the checkup target entry A (ST303).

Then the flow goes to a loop of ST304 to ST307, and the processing of comparing the board ID of the entry A and the board ID of the inspection target board is repeated while the entry A is traced back one by one. When the board ID of the entry A is matched with the board ID of the inspection target board ("YES" in ST305), a relationship between the process corresponding to the inspection target board and the process corresponding to the entry A is confirmed based on the process ID of the current entry A at step ST308.

In the confirmation processing, when the process corresponding to the entry A is identical to the process corresponding to the inspection target board, or when the process corresponding to the entry A is the process subsequent to the process corresponding to the inspection target board, the extraction flag of the entry A is changed to "1" (ST309), and the reintroduction flag of the inspection target board is changed to "1" (ST310). The pieces of information on the process ID, inspection time, board !D, extraction flag, and reintroduction flag of the inspection target board are stored as a new entry in the passage board table 420 (ST311).

On the other hand, when the process corresponding to the entry A is performed prior to the process corresponding to the inspection target board in the confirmation processing, the flow returns to the loop of ST304 to ST307 without performing steps ST309 to ST311.

In the loop of ST304 to ST307, when the entry A whose board ID is identical to that of the inspection target board cannot be found even if all the entries in the passage board table 420 are traced back, the flow goes to step ST311 while the extraction flag and the reintroduction flag are set to "0", and various pieces of information including the extraction flag and the reintroduction flag, which are set to "0", are stored as a new entry in the passage board table 420.

According to the procedure of Fig. 18, the entries (a) to (d) of Fig. 17 are stored in the passage board table 420 while the extraction flag is initially set to "0", However, when the entry (b) is registered, the extraction flag of the entry (a) is changed to "1". Similarly, when the entry (d) is registered, the extraction flag of the entry (c) is changed to "1",

On the other hand, when the entry (c) is registered, the entry (b) is extracted as the entry whose board ID is identical to that of the inspection target board in the loop of ST304 to ST307, The entry (b) corresponds to the process preceding the process corresponding to the entry (c), the extraction flag of the entry (b) is maintained to "0", The reintroduction flag of the entry (c) is also registered while set to "0".

In the processing of Fig. 18, the pieces of data corresponding to the entries (a), (b), and (d) are displayed in the graph display field 16 on the confirmation screen of the solder printing inspection machine 100, the letter "0" indicating the extraction is added only to the data corresponding to the entry (a), and only the letter "R" indicating the reintroduction is added to the data corresponding to the entry (b). Therefore, even if the board extracted in the component mounting process is reintroduced to the solder printing process, the time the extraction is generated is not mistakenly recognized, but the graph reflecting the correct recognition result can be displayed.

In the embodiment, the server 4 performs the registration processing to the passage board table 420. Alternatively, the solder printing inspection machine 100 may perform the registration processing, In such cases, while conducting communication with the component mounting inspection machine 200, the solder printing inspection machine 100 performs the processing similar to that of Fig. 18 using the information on the board received by both the inspection machines 100 and 200.

In the server 4 of the embodiment of Fig. 16, when the graph for the analytical work is produced according to the assignment from the terminal device 5, the passage board table 407 is constructed into the configuration similar to that of Fig. 17 to perform the registration processing of Fig. 18. Therefore, the board extraction in the component mounting process can be recognized without mistakes.

In each embodiment relating to the registration processing of the passage board table, the pieces of data registered in the passage board table are traced back in the retroactive manner to search the data whose board ID is identical to that of the registration target board. Alternatively, the pieces of data registered in the passage board table may be traced back in the chronological order.

## Claims

1. A method for supporting analytical work of a solder printing state of a solder printer using accumulated inspection result data, a plurality of boards being sequentially introduced and processed in a production line including the solder printer and a solder printing inspection machine (100), a unique identification code being provided on the plurality of boards, the solder printing inspection machine (100) producing inspection result data bundled with the identification code on each board and information specifying an inspection order, the inspection result data being accumulated in a solder printing inspection machine (100) or a memory of an external device, the method comprising:
a first step of focusing on each of the plurality of boards introduced to the solder printing inspection machine (100) for a purpose of inspection specifying pieces of inspection result data of the plurality of boards that are inspected before the focused board is introduced to the solder printing inspection machine (100) based on the information specifying the inspection order, checking the identification codes bundled with the pieces of inspection result data against the identification code of the focused board, and when the inspection result data bundled with the identification code identical to that of the focused board is detected by the checking, recognizing that the focused board is a board corresponding to the inspection result data bundled with the identical identification code and is reintroduced to the production line;
a second step of producing a graph in which pieces of quality data of the plurality of boards are arrayed in time series using the pieces of inspection result data of the plurality of boards inspected by the solder printing inspection machine (100), the plurality of boards including the board recognized in the first step; and
a third step of displaying the graph produced in the second step based on the recognition result in the first step while the quality data corresponding to at least one of the reintroduced board and a board corresponding to the inspection result data bundled with the identification code identical to that of the reintroduced board is explicitly shown.

2. The method according to claim 1, **characterized in that** the solder printing inspection machine (100) is configured to perform the first, second, and third steps, and to accumulate the inspection result data in a memory of the solder printing inspection machine (100),
the solder printing inspection machine (100) focuses on an inspection target board to perform the first step each time the inspection target board is received, and upon completing the inspection of the inspection target board performs the second step and the third step targeting the plurality of boards inspected prior to the inspection target board, wherein
in the third step, the quality data corresponding to the reintroduced board is explicitly shown in the graph, and when display target graph includes data of the board corresponding to the inspection result data bundled with the identification code identical to that of the reintroduced board, the data is explicitly shown as the quality data corresponding to a board extracted from the production line in a mode different from the quality data corresponding to the reintroduced board.

3. The method according to claim 1, **characterized in that** the solder printer is configured to transmit data relating to a producing condition of a board processed by the solder printer and bundled with the identification code to an external computer, the external computer being able to communicate with the solder printer and the solder printing inspection machine (100), and the solder printing inspection machine (100) is configured to transmit the inspection result data of the board to the external computer to let the inspection result data along with the data transmitted from the solder printer stored as information in a memory of the external computer,
the external computer performs the first, second, and third steps to a plurality of identical-specification boards processed by the solder printer and the solder printing inspection machine (100), wherein
in the second step, a graph in which pieces of quality data expressing quality of the boards are arrayed in time series and a graph in which pieces of data expressing the board producing conditions are arrayed in time series are produced using the information accumulated in the memory of the external computer, and
in the third step, the quality data expressing the quality and the data expressing the producing condition of the graphs produced in the second step are displayed in a line with respect to the identification code of the board, and the quality data corresponding to the inspection result data bundled with the identification code identical to that of the reintroduced board is explicitly shown as the quality data corresponding to a board extracted from the production line.

4. A solder printing inspection machine (100) provided on comprising:
an inspection performing unit that sequentially receives a plurality of boards processed through a solder printing by a solder printer to inspect a printing state of solder, a unique identification code being each of the plurality of boards;
an inspection result accumulation unit that produces and accumulates inspection result data of each of the plurality of boards therein or in an external device, the inspection result data being bundled with the identification code of each of the plurality of boards and information specifying an inspection order;
an information display unit that produces a graph using the produced inspection result data and displays the graph on a monitor device, the graph showing pieces of quality data expressing quality of the boards arrayed in time series; and
a recognition unit that specifies pieces of inspection result data of the plurality of boards that have been inspected before an inspection target board is received based on the information specifying the inspection order each time the inspection target board is received, checks the identification codes bundled with the pieces of inspection result data against the identification code of the inspection target board, and when the inspection result data bundled with the identification code identical to that of the inspection target board is detected by the checking, recognizes that the inspection target board is a board corresponding to the inspection result data bundled with the identical identification code and is reintroduced to the production line, wherein
the information display unit updates display target graph using the inspection result data produced for the board each time the inspection of the received board is ended, and explicitly displays the quality data corresponding to the reintroduced board in the graph based on the recognition result of the recognition unit.

5. The solder printing inspection machine (100) according to claim 4, **characterized in that** when the display target graph includes the quality data of the board corresponding to the inspection result data bundled with the identification code identical to that of the reintroduced board, the information display unit explicitly shows the data as a quality data corresponding to the board extracted from the production line in a mode different from the quality data corresponding to the reintroduced board.

## Patentansprüche

1. Verfahren zum Unterstützen einer analytischen Bearbeitung eines Lötmitteldruckzustands eines Lötmitteldruckers unter Verwendung angesammelter Inspektionsergebnisdaten, wobei eine Mehrzahl von Platten der Reihe nach zugeführt und auf einer Fertigungsstrecke, die den Lötmitteldrucker und eine Lötmitteldruckinspektionsmaschine (100) umfasst, verarbeitet werden, wobei ein einmaliger Kennzeichnungscode auf jeder von der Mehrzahl von Platten vorgesehen ist, wobei die Lötmitteldruckinspektionsmaschine (100) Inspektionsergebnisdaten gebündelt mit dem Kennzeichnungscode auf jeder Platte und einer die Inspektionsreihenfolge angebenden Information erzeugt, wobei die Inspektionsergebnisdaten in der Lötmitteldruckinspektionsmaschine (100) oder einem Speicher eines externen Geräts angesammelt werden, das Verfahren umfassend:
einen ersten Schritt des Fokussierens auf jede von der Mehrzahl von Platten, die der Lötmitteldruckinspektionsmaschine (100) zugeführt werden, zum Zweck der Inspektion, wobei Teile von Inspektionsergebnisdaten von der Mehrzahl von Platten, die vor dem Zuführen der fokussierten Platte der Lötmitteldruckinspektionsmaschine (100) inspiziert wurden, anhand der die Inspektionsreihenfolge angebenden Information spezifiziert werden, wobei die mit den Teilen von Inspektionsergebnisdaten gebündelten Kennzeichnungscodes gegen den Kennzeichnungscode der fokussierten Platte kontrolliert werden und wobei, wenn die Inspektionsergebnisdaten, die mit dem mit der fokussierten Platte identischen Kennzeichnungscode gebündelt sind, durch das Kontrollieren detektiert wurden, erkannt wird, dass die fokussierte Platte eine Platte ist, die den mit dem identischen Kennzeichnungscode gebündelten Inspektionsergebnisdaten entspricht und der Fertigungsstrecke erneut zugeführt ist;
einen zweiten Schritt des Erzeugens eines Diagramms, in dem Teile von Qualitätsdaten der Mehrzahl von Platten unter Verwendung der Teile von Inspektionsergebnisdaten der Mehrzahl von Platten, die von der Lötmitteldruckinspektionsmaschine (100) inspiziert wurden, in Zeitfolgen aufgestellt werden, wobei die Mehrzahl von Platten die im ersten Schritt erkannten Platten umfasst; und
einen dritten Schritt des Anzeigens des Diagramms, das im zweiten Schritt anhand der Ergebnisses der Erkennung im ersten Schritt erzeugt wurde, während die Qualitätsdaten, die mindestens einer der erneut zugeführten Platten entsprechen, und eine Platte, die den Inspektionsergebnisdaten entspricht, die mit dem Kennzeichnungscode gebündelt sind, der mit demjenigen der erneut zugeführten Platte identisch ist, explizit gezeigt werden.

2. Verfahren nach Anspruch 1, **dadurch gekennzeichnet, dass** die Lötmitteldruckinspektionsmaschine (100) dazu ausgelegt ist, den ersten, zweiten und dritten Schritte auszuführen und die Inspektionsergebnisdaten in einem Speicher der Lötmitteldruckinspektionsmaschine (100) anzusammeln,
die Lötmitteldruckinspektionsmaschine (100) jedes Mal, wenn eine Inspektionszielplatte erhalten wird, auf die Inspektionszielplatte fokussiert, um den ersten Schritt auszuführen, und nach Abschluss der Inspektion der Inspektionszielplatte den zweiten Schritt und den dritten Schritt ausführt, auf die Mehrzahl von Platten zielend, die vor der Inspektionszielplatte inspiziert wurden, wobei
im dritten Schritt die Qualitätsdaten, die der erneut zugeführten Platte entsprechen, im Diagramm explizit gezeigt werden, und dann, wenn ein Anzeigezieldiagramm Daten der Platte umfasst, die den Inspektionsergebnisdaten entspicht, die mit dem Kennzeichnungscode gebündelt sind, der mit demjenigen der erneut zugeführten Platte identisch ist, die Daten explizit als Qualitätsdaten, die einer aus der Fertigungsstrecke herausgezogenen Platte entsprechen, in einem anderen Modus als die der erneut zugeführten Platte entsprechenden Qualitätsdaten gezeigt werden.

3. Verfahren nach Anspruch 1, **dadurch gekennzeichnet, dass** der Lötmitteldrucker dazu ausgelegt ist, Daten in Bezug auf einen Fertigungszustand einer vom Lötmitteldrucker verarbeiteten Platte, mit dem Kennzeichnungscode gebündelt, an einen externen Computer zu übermitteln, wobei der externe Computer fähig ist, mit dem Lötmitteldrucker und der Lötmitteldruckinspektionsmaschine (100) zu kommunizieren, und die Lötmitteldruckinspektionsmaschine (100) dazu ausgelegt ist, die Inspektionsergebnisdaten der Platte an den externen Computer zu übermitteln, sodass die Inspektionsergebnisdaten zusammen mit den vom Lötmitteldrucker übermittelten Daten als eine Information in einem Speicher des externen Computers gespeichert werden,
der externe Computer den ersten, zweiten und dritten Schritte an einer Mehrzahl von identisch spezifizierten Platten, die vom Lötmitteldrucker und der Lötmitteldruckinspektionsmaschine (100) verarbeitet wurden, ausführt, wobei
im zweiten Schritt ein Diagramm, in dem Teile von Qualitätsdaten, die Qualität von Platten ausdrücken, in Zeitfolgen aufgestellt sind, und ein Diagramm, in dem Teile von Daten, die die Plattenfertigungszustände ausdrücken, in Zeitfolgen aufgestellt sind, anhand der im Speicher des externen Computers angesammelten Information erzeugt werden, und
im dritten Schritt die Qualitätsdaten, die Qualität ausdrücken, und die Daten, die den Fertigungszustand ausdrücken, von den im zweiten Schritt erzeugten Diagrammen in einer Zeile bezüglich dem Kennzeichnungscode der Platte angezeigt werden, und die Qualitätsdaten, die den Inspektionsergebnisdaten entsprechen, die mit dem Kennzeichnungscode gebündelt sind, der mit demjenigen der erneut zugeführten Platte identisch ist, explizit als die Qualitätsdaten, die einer aus der Fertigungsstrecke herausgezogenen Platte entsprechen, gezeigt werden.

4. Lötmitteldruckinspektionsmaschine (100), umfassend:
eine Inspektion ausführende Einheit, die der Reihe nach eine Mehrzahl von Platten, die durch ein Lötmitteldrucken von einem Lötmitteldrucker verarbeitet wurden, erhält, um einen Druckzustand des Lötmittels zu inspizieren, wobei ein einmaliger Kennzeichnungscode auf jeder von der Mehrzahl von Platten vorgesehen ist;
eine Inspektionsergebnisansammlungseinheit, die Inspektionergebnisdaten von jeder von der Mehrzahl von Platten darin oder in einem externen Gerät erzeugt und ansammelt, wobei die Inspektionergebnisdaten mit dem Kennzeichnungscode von jeder von der Mehrzahl von Platten und einer eine Inspektionsreihenfolge angebenden Information gebündelt sind;
eine Informationsanzeigeeinheit, die unter Verwendung der erzeugten Inspektionergebnisdaten ein Diagramm erzeugt und das Diagramm auf einem Überwachungsgerät anzeigt, wobei das Diagramm in Zeitfolgen aufgestellte Teile von Qualitätsdaten, die Qualität der Platten ausdrücken, zeigt; und
eine Erkennungseinheit, die jedes Mal, wenn eine Inspektionszielplatte erhalten wird, Teile von Inspektionsergebnisdaten von der Mehrzahl von Platten, die vor dem Erhalten der Inspektionszielplatte inspiziert worden sind, anhand der die Inspektionsreihenfolge angebenden Information spezifiziert, die mit den Teilen von Inspektionsergebnisdaten gebündelten Kennzeichnungscodes gegen den Kennzeichnungscode der Inspektionszielplatte kontrolliert und, wenn die Inspektionsergebnisdaten, die mit dem mit demjenigen der Inspektionszielplatte identischen Kennzeichnungscode gebündelt sind, durch das Kontrollieren detektiert wurden, erkennt, dass die Inspektionszielplatte eine Platte ist, die den mit dem identischen Kennzeichnungscode gebündelten Inspektionsergebnisdaten entspricht und der Fertigungsstrecke erneut zugeführt ist, wobei
die Informationsanzeigeeinheit ein Anzeigezieldiagramm unter Verwendung der für die Platte erzeugten Inspektionsergebnisdaten jedes Mal aktualisiert, wenn die Inspektion der erhaltenen Platte beendet wird, und die Qualitätsdaten, die der erneut zugeführten Platte entsprechen, im Diagramm anhand des Erkennungsergebnisses der Erkennungseinheit explizit zeigt.

5. Lötmitteldruckinspektionsmaschine (100) nach Anspruch 4, **dadurch gekennzeichnet, dass** dann, wenn das Anzeigezieldiagramm die Qualitätsdaten der Platte umfasst, die den Inspektionsergebnisdaten entspicht, die mit dem Kennzeichnungscode gebündelt sind, der mit demjenigen der erneut zugeführten Platte identisch ist, die Informationsanzeigeeinheit die Daten explizit als Qualitätsdaten, die der aus der Fertigungsstrecke herausgezogenen Platte entsprechen, in einem anderen Modus als die der erneut zugeführten Platte entsprechenden Qualitätsdaten zeigt.

## Revendications

1. Procédé d'assistance au travail analytique d'un état d'impression de brasure d'une imprimante de brasure en utilisant des données de résultat d'inspection accumulées, une pluralité de cartes étant séquentiellement introduites et traitées dans une ligne de production incluant l'imprimante de brasure et une machine d'inspection d'impression de brasure (100), un code d'identification unique étant fourni sur chacune de la pluralité de cartes, la machine d'inspection d'impression de brasure (100) produisant des données de résultat d'inspection groupées avec le code d'identification sur chaque carte et des informations spécifiant un ordre d'inspection, les données de résultat d'inspection étant accumulées dans une machine d'inspection d'impression de brasure (100) ou une mémoire d'un dispositif externe, le procédé comprenant :
une première étape de focalisation sur chacune de la pluralité de cartes introduites dans la machine d'inspection d'impression de brasure (100) à des fins d'inspection spécifiant des éléments de données de résultat d'inspection de la pluralité de cartes qui sont inspectées avant que la carte focalisée soit introduite dans la machine d'inspection d'impression de brasure (100) en se basant sur des informations spécifiant l'ordre d'inspection, de vérification des codes d'identification groupés avec les éléments de données de résultat d'inspection par rapport au code d'identification de la carte focalisée, et lorsque les données de résultat d'inspection groupées avec le code d'identification identique à celui de la carte focalisée sont détectées par la vérification, de reconnaissance que la carte focalisée est une carte correspondant aux données de résultat d'inspection groupées avec le code d'identification identique et est réintroduite dans la ligne de production ;
une deuxième étape de production d'un graphique dans lequel des éléments de données de qualité de la pluralité de cartes sont agencés en séries temporelles utilisant les éléments de données de résultat d'inspection de la pluralité de cartes inspectées par la machine d'inspection d'impression de brasure (100), la pluralité de cartes incluant la carte reconnue dans la première étape ; et
une troisième étape d'affichage du graphique produit dans la deuxième étape en se basant sur le résultat de reconnaissance de la première étape pendant que les données de qualité correspondant à au moins l'une des cartes réintroduites et d'une carte correspondant aux données de résultat d'inspection groupées avec le code d'identification identique à celui de la carte réintroduite sont explicitement montrées.

2. Procédé selon la revendication 1, **caractérisée en ce que** la machine d'inspection d'impression de brasure (100) est configurée pour réaliser les première, deuxième et troisième étapes, et pour accumuler les données de résultat d'inspection dans une mémoire de la machine d'inspection d'impression de brasure (100),
la machine d'inspection d'impression de brasure (100) se focalise sur une carte cible d'inspection pour réaliser la première étape à chaque fois que la carte cible d'inspection est reçue, et lors de l'achèvement de l'inspection de la carte cible d'inspection, réalise la deuxième étape et la troisième étape ciblant la pluralité de cartes inspectées avant la carte cible d'inspection, dans laquelle
dans la troisième étape, les données de qualité correspondant à la carte réintroduite sont explicitement montrées dans le graphique, et lorsque le graphique cible d'affichage inclut des données de la carte correspondant aux données de résultat d'inspection groupées avec le code d'identification identique à celui de la carte réintroduite, les données sont explicitement montrées comme les données de qualité correspondant à une carte extraite de la ligne de production dans un mode différent des données de qualité correspondant à la carte réintroduite.

3. Procédé selon la revendication 1, **caractérisée en ce que** l'imprimante de brasure est configurée pour transmettre des données relatives à une condition de production d'une carte traitée par l'imprimante de brasure et groupées avec le code d'identification à un ordinateur externe, l'ordinateur externe pouvant communiquer avec l'imprimante de brasure et la machine d'inspection d'impression de brasure (100), et la machine d'inspection d'impression de brasure (100) est configurée pour transmettre les données de résultat d'inspection de la carte à l'ordinateur externe pour laisser les données de résultats d'inspection ainsi que les données transmises à partir de l'imprimante de brasure stockées comme informations dans une mémoire de l'ordinateur externe,
l'ordinateur externe réalise les première, deuxième et troisième étapes sur une pluralité de cartes à spécification identique traitées par l'imprimante de brasure et la machine d'inspection d'impression de brasure (100), dans laquelle
dans la deuxième étape, un graphique dans lequel des éléments de données de qualité exprimant la qualité des cartes sont agencés en séries temporelles et un graphique dans lequel des éléments de données exprimant les conditions de production de cartes sont agencés en séries temporelles sont produits en utilisant les informations accumulées dans la mémoire de l'ordinateur externe ; et
dans la troisième étape, les données de qualité exprimant la qualité et les données exprimant les conditions de production des graphiques produits dans la deuxième étape sont affichées dans une ligne par rapport au code d'identification de la carte, et les données de qualité correspondant aux données de résultat d'inspection groupées avec le code d'identification identique à celui de la carte réintroduite sont explicitement montrées comme les données de qualité correspondant à une carte extraite de la ligne de production.

4. Machine d'inspection d'impression de brasure (100) comprenant :
une unité de réalisation d'inspection qui reçoit séquentiellement une pluralité de cartes traitées via une impression de brasure par une imprimante de brasure pour inspecter un état d'impression d'une brasure, un code d'identification unique étant fourni sur chacune de la pluralité de cartes ;
une unité d'accumulation de résultats d'inspection qui produit et accumule des données de résultat d'inspection de chacune de la pluralité de cartes dans celle-ci ou dans un dispositif externe, les données de résultats d'inspection étant groupées avec le code d'identification de chacune de la pluralité de cartes et d'informations spécifiant un ordre d'inspection ;
une unité d'affichage d'informations qui produit un graphique utilisant les données de résultat d'inspection produites et affiche le graphique dans un dispositif de surveillance, le graphique montrant des éléments de données de qualité exprimant la qualité des cartes agencées en séries temporelles ; et
une unité de reconnaissance qui spécifié des éléments de données de résultat d'inspection de la pluralité de cartes qui ont été inspectées avant qu'une carte cible d'inspection soit reçue en se basant sur les informations spécifiant l'ordre d'inspection à chaque fois que la carte cible d'inspection est reçue, vérifie les codes d'identification groupés avec les éléments de données de résultat d'inspection par rapport au code d'identification de la carte cible d'inspection, et lorsque les données de résultat d'inspection groupées avec le code d'identification identique à celui de la carte cible d'inspection sont détectées par la vérification, reconnaît que la carte cible d'inspection est une carte correspondant aux données de résultat d'inspection groupées avec le code d'identification identique et réintroduite dans la ligne de production, dans laquelle
l'unité d'affichage d'informations met à jour un graphique cible d'affichage utilisant les données de résultat d'inspection produites pour la carte à chaque fois que l'inspection de la carte reçue se termine, et affiche explicitement les données de qualité correspondant à la carte réintroduite dans le graphique en se basant sur le résultat de reconnaissance de l'unité de reconnaissance.

5. Machine d'inspection d'impression de brasure (100) selon la revendication 4, **caractérisée en ce que** lorsque le graphique cible d'affichage inclut les données de qualité de la carte correspondant aux données de résultat d'inspection groupées avec le code d'identification identique à celui de la carte réintroduite, l'unité d'affichage d'informations montre explicitement les données comme des données de qualité correspondant à la carte extraite de la ligne de production dans un mode différent des données de qualité correspondant à la carte réintroduite.
